(19) **Europäisches Patentamt**
**European Patent Office**
**Office européen des brevets**

(11) **EP 4 377 259 B1**

(12) **EUROPÄISCHE PATENTSCHRIFT**

(45) Veröffentlichungstag und Bekanntmachung des Hinweises auf die Patenterteilung:
**10.12.2025 Patentblatt 2025/50**

(21) Anmeldenummer: **21759032.2**

(22) Anmeldetag: **29.07.2021**

(51) Internationale Patentklassifikation (IPC):
*C01B 33/029* (2006.01)   *H01M 4/02* (2006.01)
*H01M 4/04* (2006.01)   *H01M 10/0525* (2010.01)
*C23C 16/04* (2006.01)   *C23C 16/24* (2006.01)
*C23C 16/26* (2006.01)   *C23C 16/44* (2006.01)
*H01M 4/134* (2010.01)   *H01M 4/38* (2006.01)
*H01M 4/62* (2006.01)

(52) Gemeinsame Patentklassifikation (CPC):
**C01B 33/029; C23C 16/045; C23C 16/24;
C23C 16/26; C23C 16/4417; H01M 4/134;
H01M 4/386; H01M 4/621; H01M 10/0525;**
C01P 2006/12; H01M 2004/027; Y02E 60/10

(86) Internationale Anmeldenummer:
**PCT/EP2021/071308**

(87) Internationale Veröffentlichungsnummer:
**WO 2023/006209 (02.02.2023 Gazette 2023/05)**

(54) **VERFAHREN ZUR HERSTELLUNG VON SILICIUM ENTHALTENDEN MATERIALIEN IN EINEM KASKADENREAKTORSYSTEM**

PROCESS FOR MANUFACTURING SILICON-CONTAINING MATERIALS IN A CASCADE REACTOR SYSTEM

PROCÉDÉ DE PRODUCTION DE MATÉRIAUX CONTENANT DU SILICIUM DANS UN SYSTÈME DE RÉACTEUR EN CASCADE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**05.06.2024 Patentblatt 2024/23**

(73) Patentinhaber: **Wacker Chemie AG**
**81671 München (DE)**

(72) Erfinder:
• **TILLMANN, Jan**
**80636 München (DE)**
• **KNEISSL, Sebastian**
**83059 Kolbermoor (DE)**
• **DRÄGER, Christoph**
**81369 München (DE)**
• **KALYAKINA, Alena**
**81379 München (DE)**
• **RENNER, Thomas**
**81739 München (DE)**

(74) Vertreter: **Belz, Ferdinand et al**
**Wacker Chemie AG**
**Gisela-Stein-Straße 1**
**81671 München (DE)**

(56) Entgegenhaltungen:
**GB-A- 2 584 615     GB-A- 2 587 326
US-B1- 10 508 335**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## EP 4 377 259 B1

**Beschreibung**

Die Erfindung betrifft ein Verfahren zur Herstellung von Silicium enthaltenden Materialien durch thermische Zersetzung von Silicium-Präkursoren in Anwesenheit von porösen Partikeln, wobei Silicium in Poren sowie auf der Oberfläche der porösen Partikel abgeschieden wird.

Als Speichermedien für elektrischen Strom sind Lithium-Ionen-Batterien gegenwärtig die praxistauglichen elektrochemischen Energiespeicher mit den höchsten Energiedichten. Lithium-Ionen-Batterien werden vor allem im Bereich der tragbaren Elektronik, für Werkzeuge und auch für elektrisch angetriebene Transportmittel, wie Fahrräder, Roller oder Automobile, genutzt. Als Aktivmaterial für die negative Elektrode ("Anode") entsprechender Batterien ist gegenwärtig graphitischer Kohlenstoff weit verbreitet. Nachteilig ist jedoch die relativ niedrige elektrochemische Kapazität von derartigen graphitischen Kohlenstoffen, die theoretisch höchstens 372 mAh pro Gramm Graphit beträgt und somit nur etwa einem Zehntel der mit Lithiummetall theoretisch erreichbaren elektrochemischen Kapazität entspricht. Alternative Aktivmaterialien für die Anode verwenden einen Zusatz von Silicium, wie beispielsweise in der EP 1730800 B1, der US 10,559,812 B2, der US 10,819,400 B2, oder der EP 3335262 B1 beschrieben. Silicium bildet mit Lithium binäre elektrochemisch aktive Legierungen, die sehr hohe elektrochemisch erreichbare Lithiumgehalte von bis zu 3579 mAh pro Gramm Silicium ermöglichen [M. Obrovac, V.L. Chevrier Chem. Rev. 2014, 114, 11444].

Die Ein- und Auslagerung von Lithium-Ionen in Silicium ist mit dem Nachteil verbunden, dass dabei eine sehr starke Volumenänderung eintritt, die bei vollständiger Einlagerung bis zu 300% erreichen kann. Derartige Volumenänderungen setzen das Silicium enthaltende Aktivmaterial einer starken mechanischen Belastung aus, auf Grund derer das Aktivmaterial schließlich auseinanderbrechen kann. Dieser auch als elektrochemische Mahlung bezeichnete Prozess führt im Aktivmaterial und in der Elektrodenstruktur zu einem Verlust der elektrischen Kontaktierung und damit zum nachhaltigen, irreversiblen Verlust der Kapazität der Elektrode.

Weiterhin reagiert die Oberfläche des Silicium enthaltenden Aktivmaterials mit Bestandteilen des Elektrolyten unter kontinuierlicher Bildung passivierender Schutzschichten (Solid Electrolyte Interphase; SEI). Die gebildeten Komponenten sind nicht mehr elektrochemisch aktiv. Das darin gebundene Lithium steht dem System nicht mehr zur Verfügung, was zu einem ausgeprägten kontinuierlichen Kapazitätsverlust der Batterie führt. Aufgrund der extremen Volumenänderung des Siliciums während des Lade- bzw. Entladevorgangs der Batterie bricht die SEI regelmäßig auf, wodurch weitere, noch nicht belegte Oberflächen des Silicium enthaltenden Aktivmaterials freigelegt werden, die dann einer weiteren SEI-Bildung ausgesetzt sind. Da in der Vollzelle die Menge an mobilem Lithium, welches der nutzbaren Kapazität entspricht, durch das Kathodenmaterial begrenzt ist, wird dieses zunehmend verbraucht und die Kapazität der Zelle sinkt bereits nach wenigen Zyklen in anwendungstechnisch inakzeptablem Ausmaß.

Die Abnahme der Kapazität im Laufe mehrerer Lade- und Entladezyklen wird auch als Fading oder kontinuierlicher Kapazitätsverlust bezeichnet und ist in der Regel irreversibel.

Als Aktivmaterialien für Anoden von Lithium-Ionen-Batterien sind eine Reihe von Silicium-Kohlenstoff-Kompositpartikeln beschrieben worden, in denen das Silicium ausgehend von gasförmigen oder flüssigen Präkursoren in poröse Kohlenstoffpartikel eingelagert wird.

Beispielsweise beschreibt die US 10,147,950 B2 die Abscheidung von Silicium aus Monosilan $SiH_4$ in einem porösen Kohlenstoff in einem Rohrofen oder vergleichbaren Ofentypen bei erhöhten Temperaturen von 300 bis 900°C, bevorzugt unter Bewegung der Partikel, durch einen CVD- ("chemical vapor deposition") oder PE-CVD-Prozess ("plasma-enhanced chemical vapor deposition").

Dabei kommt eine Mischung von 2 mol-% Monosilan mit Stickstoff als Inertgas zum Einsatz. Die geringe Konzentration des Silicium-Präkursors im Gasgemisch führt dabei zu sehr langen Reaktionszeiten. Weiterhin offenbart die US 10,147,950 B2 eine Vielzahl möglicher Kombinationen von unterschiedlichen Temperaturbereichen von 300 bis 900°C mit unterschiedlichen Druckbereichen von 0,01 bis 100 bar zur Durchführung der Abscheidung von Silicium auf und in porösen Ausgangsstoffen.

Eine analoge Vorgehensweise ist in US 10,424,786 B1 beschrieben, in der die Silicium-Präkursoren als Mischung mit Inertgas bei einem Gesamtdruck von 1,013 bar eingebracht werden. Die WO2012/097969 A1 beschreibt die Abscheidung von feinsten Siliciumpartikeln im Bereich von 1 bis 20 nm durch Erwärmung von Silanen als Silicium-Präkursor auf porösen Kohlenstoffträgern bei 200 bis 950°C, wobei das Silan mit einem Inertgas verdünnt wird, um Agglomeration der abgeschiedenen Silicium-Partikel bzw. die Bildung dicker Schichten zu vermeiden, wobei die Abscheidung in einem Druckbereich von 0,1 bis 5 bar erfolgt.

Motevalian et al, Ind. Eng. Chem. Res. 2017,56, 14995, beschreiben die Abscheidung von Silicium-Schichten bei erhöhtem Druck, allerdings nicht in Anwesenheit einer porösen Matrix. Wiederum ist der eingesetzte Silicium-Präkursor, in diesem Fall Monosilan $SiH_4$, nur in geringer Konzentration von höchstens 5 mol-% im Gesamtgasvolumen vorhanden.

US 10 508 335 B1 betrifft betrifft ein Verfahren zur Herstellung von partikelförmigen Materialien mit hohen elektrochemischen Kapazitäten, die für die Verwendung als aktive Anodenmaterialien in wiederaufladbaren Metall-Ionen-Batterien geeignet sind. In einem Aspekt stellt US 10 508 335 B1 ein Verfahren zur Herstellung eines teilchenförmigen Materials bereit, das eine Vielzahl von Verbundteilchen umfasst. Das Verfahren umfasst das Bereitstellen teilchenförmiger poröser Kohlenstoffgerüste, die Mikroporen und/oder Mesoporen umfassen, wobei die porösen Kohlenstoffgerüste einen D50-Teilchendurchmesser von mindestens 50 μm aufweisen; das Abscheiden eines elektroaktiven Materials, das aus Silizium und dessen Legierungen ausgewählt ist, in die Mikroporen und/oder Mesoporen der porösen Kohlenstoffgerüste unter Verwendung eines chemischen Dampfinfiltrationsverfahrens in einem Wirbelschichtreaktor, um Zwischenpartikel bereitzustellen; und das Zerkleinern der Zwischenpartikel, um die Verbundpartikel bereitzustellen.

GB 2 587 326 A betrifft ein Verfahren zur Herstellung von Si-haltigen Verbundteilchen in einer Wirbelschicht, umfassend (i) das Bereitstellen von porösen leitfähigen Teilchen mit Mesoporen und/oder Mikroporen, einem D50-Teilchendurchmesser zwischen 1-30 μm, einem PD50-Porendurchmesser ≤ 10 nm und einem Gesamtporenvolumen von Mikroporen und Mesoporen im Bereich von 0,4-2,2 cm3/g, (ii) das Kombinieren der porösen leitfähigen Teilchen mit einem teilchenförmigen Zusatzstoff mit einem D50-Teilchendurchmesser zwischen 40-300 μm, einer Teilchendichte zwischen 1,3-6 g/cm3 und einer BET-Oberfläche ≤ 200 m2/g, wobei das Massenverhältnis der porösen leitfähigen Teilchen zu dem teilchenförmigen Zusatzstoff 95:5 bis 70:30 beträgt, und (iii) Leiten eines Fluidisierungsgases, das ein Si-Vorläufergas einschließt, durch die kombinierten Teilchen mit einer Gasgeschwindigkeit, die eine Fluidisierung der kombinierten Teilchen bewirkt, und bei einer Temperatur, die wirksam ist, um eine Abscheidung von Si in den Poren der porösen leitfähigen Teilchen zu bewirken (chemische Dampfinfiltration; CVI). Die Eigenschaften des partikelförmigen Zusatzstoffs werden so gewählt, dass sich die Partikel anschließend leichter trennen lassen, während sie gleichzeitig eine wirksame Fluidisierung der kombinierten Partikel während des CVI-Prozesses ermöglichen. Die porösen leitfähigen Teilchen bestehen vorzugsweise aus Kohlenstoff, können aber auch aus porösen Metalloxiden (z. B. Titanoxid) bestehen. Die Verbundteilchen werden vorzugsweise als Anodenmaterial in einer wiederaufladbaren Metall-Ionen-Batterie verwendet.

GB 2 584 615 A betrifft ein teilchenförmiges Material bestehend aus einer Vielzahl von Verbundteilchen, wobei die Verbundteilchen umfassen: (a) ein poröses Kohlenstoffgerüst, das Mikroporen und Mesoporen mit einem Gesamtporenvolumen von 0,4 bis 0,75 (P1) cm3/g einschließt, wobei der Mikroporenvolumenanteil im Bereich von 0,55 bis 0,85 liegt, bezogen auf das Gesamtvolumen der Mikroporen und Mesoporen; und (b) eine Vielzahl von Siliziumdomänen im Nanomaßstab, die sich innerhalb der Poren des porösen Kohlenstoffgerüsts befinden. Das Gewichtsverhältnis von Si zum porösen Kohlenstoffgerüst in den Verbundteilchen liegt im Bereich von [0,9 x P1 bis 1,8 x P1] : 1, d. h. die relative Menge an Si, die die Poren füllt, hängt vom Gesamtporenvolumen ab. Die Verbundteilchen sind elektroaktiv und können als Teil einer Zusammensetzung bereitgestellt werden, die auch mindestens ein Bindemittel, ein leitfähiges Additiv und ein zusätzliches teilchenförmiges elektroaktives Material enthält, und zur Bildung einer negativen Elektrode in einer Metall-Ionen-Batterie, insbesondere einer Li-Ionen-Batterie, verwendet werden. Die Verbundteilchen können durch chemische Dampfinfiltration (CVI) eines Si-haltigen Vorläufers in die Porenstruktur eines porösen Kohlenstoffgerüsts erhalten werden.

Die oben beschriebenen Verfahren weisen eine Reihe gravierender Nachteile auf. Der Silicium-Präkursor wird zumeist in geringem Absolut- und Partialdruck und damit geringer Konzentration eingesetzt, was lange Reaktionszeiten zum Erreichen hoher Siliciumanteile im Silicium enthaltenden Material erforderlich macht. Zudem ist bei diesen Verfahren nachteilig, dass nur ein geringer Teil des zugeführten Reaktivgases abreagiert, so dass das Reaktorabgas aufwändig zurückgeführt oder entsorgt werden muss, was die Kosten insbesondere bei Verwendung von sicherheitstechnisch anspruchsvollen Silicium-Präkursoren weiter steigert.

Vor diesem Hintergrund bestand die Aufgabe, ein Verfahren für die Herstellung Silicium enthaltender Materialien, vorzugsweise mit hoher Speicherkapazität für Lithium-Ionen, welche bei Einsatz als Aktivmaterial in Anoden von Lithium-Ionen-Batterien eine hohe Zyklenfestigkeit ermöglichen, ausgehend von porösen Partikeln und Silicium-Präkursoren bereitzustellen, welches technisch einfach umsetzbar ist und die Nachteile der oben beschriebenen Verfahren des Stands der Technik insbesondere in Bezug auf die Reaktionszeiten nicht aufweist.

Überraschenderweise wurde die Aufgabe im Wesentlichen durch ein Verfahren gelöst, in welchem in einem Kaskadenreaktorsystem durch Zersetzung von Silicium-Präkursoren bei einem Druck von mindestens 7 bar Silicium in Poren und auf der Oberfläche von porösen Partikel abgeschieden wird. Dies ist insofern besonders überraschend, als dass von Verfahren zur Herstellung von polykristallinem Silicium bekannt ist, dass es bei der Abscheidung von Silicium bei höherem Druck verstärkt zu unerwünschter Staubbildung kommt (J.O. Odden et al., Solar Energy Mat. & Solar Cells 2005, 86, 165.), was für die Abscheidung von Silicium auf der inneren Oberfläche der Poren und der äußeren Oberfläche der porösen Partikel sowie für die Produktausbeute kontraproduktiv ist. Dieser nachteilige Effekt wird durch das erfindungsgemäße Verfahren überraschenderweise überwunden.

Die Herstellung von Silicium enthaltenden Materialien, beispielsweise als Aktivmaterialien für Anoden von Lithium-Ionen-Batterien, ausgehend von porösen Partikeln und Silicium-Präkursoren unter erfindungsgemäßem Druck ist ökonomisch von besonderem Interesse, da dadurch überraschend erhöhte Stoffmengen an Silicium-Präkursoren in den porösen Partikeln und damit verkürzte Reaktionszeiten ermöglicht werden. Ein weiterer ökonomischer Vorteil des Verfahrens besteht in der höheren Silicium-Ausbeute im Verhältnis zum eingesetzten Silicium-Präkursor. Zudem erfolgt eine besonders gleichmäßige Abscheidung von Silicium auf und vor allem in den porösen Partikeln, was zu einer hohen Stabilität des resultierenden Silicium enthaltenden Materials in der Anwendung als Aktivmaterial in Anoden für Lithium-Ionen-Batterien bei gleichzeitig niedriger Volumenänderung in der Zyklisierung führt. Im Gegensatz zur Herstellung der betreffenden Materialien in nur einem Reaktor (nicht erfindungsgemäß) hat die Durchführung im Kaskadenreaktor den Vorteil, dass die langen Abkühl- und Aufheizphasen eines Reaktor vermindert werden. Dieses birgt einen zeitlichen und energietechnischen Vorteil gegenüber nur einem Reaktor und führt zu einer geringeren Materialbeanspruchung der Reaktoren.

Gegenstand der Erfindung ist ein Verfahren zur Herstellung von Silicium enthaltenden Materialien durch thermische Zersetzung von einem oder mehreren Silicium-Präkursoren in Anwesenheit von einem oder mehreren porösen Partikeln, wobei Silicium in Poren und auf der Oberfläche der porösen Partikel abgeschieden wird, in einem Kaskadenreaktorsystem umfassend mehrere Reaktoren.

In einer bevorzugten Ausführungsform umfasst das Verfahren zumindest die Phasen 1 bis 7:

Phase 1:  Befüllen eines Reaktors A mit porösen Partikeln und Vorbehandlung der Partikel,

Phase 2:  Transfer der vorbehandelten Partikel in einen Reaktor B und Beaufschlagen des Reaktors mit einer Reaktivkomponente enthaltend zumindest einen Silicium-Präkursor,

Phase 3:  Aufheizen des Reaktors B auf eine Zieltemperatur, bei der die Zersetzung des Silicium-Präkursors im Reaktor beginnt,

Phase 4:  Zersetzung des Silicium-Präkursors unter Abscheidung von Silicium in Poren und auf der Oberfläche der porösen Partikel wobei die Silicium enthaltenden Materialien entstehen und wobei der Druck auf mindestens 7 bar ansteigt,

Phase 5:  Abkühlen des Reaktors B,

Phase 6:  Entfernen von im Zuge der Abscheidung gebildeten gasförmigen Reaktionsprodukten aus dem Reaktor B und Transfer der Silicium enthaltenden Materialien in einen Reaktor C,

Phase 7:  Entnahme der Silicium enthaltenden Materialien aus dem Reaktor C.

In einer bevorzugten Ausführungsform ist die Phase 1 wie folgt ausgestaltet:

Phase 1

Phase 1.1:  Befüllen des Reaktors A mit den porösen Partikeln,

Phase 1.2:  Vorbehandlung der Partikel in Reaktor A,

Phase 1.3:  Transfer der vorbehandelten Partikel in den Reaktor B oder Zwischenlagerung in einen Vorratsbehälter D und anschließender Transfer in den Reaktor B, oder das Material verbleibt im Reaktor A.

In einer bevorzugten Ausführungsform ist die Phase 2 wie folgt ausgestaltet:

Phase 2

Phase 2.1:  Aufheizen oder Abkühlen der Partikel in den Reaktor B,

gegebenenfalls Phase 2.2:  Einstellen des Drucks im Reaktor B

gegebenenfalls Phase 2.3:  Beaufschlagen des Reaktors B mit mindestens einer Silicium-freien Reaktivkomponenten,

Phase 2.4:  Beaufschlagen des Reaktors B mit mindestens einer Reaktivkomponente enthaltend zumindest einen Silicium-Präkursor.

In einer bevorzugten Ausführungsform ist die Phase 3 wie folgt ausgestaltet:

Phase 3

Phase 3.1: Aufheizen des Reaktors B auf eine Zieltemperatur, bei der die Zersetzung der Reaktivkomponente im Reaktor B beginnt.

Wenn mindestens eine Silicium-freie Reaktivkomponente im Reaktor B ist, folgt vorzugsweise Phase 3.2:

Phase 3.2: Zersetzung der Reaktivkomponente, die keinen Si-Präkursor enthält.

In einer bevorzugten Ausführungsform ist die Phase 4 wie folgt ausgestaltet:

Phase 4

Phase 4.1: Zersetzung des Silicium-Präkursors unter Abscheidung von Silicium in Poren und auf der Oberfläche der porösen Partikel, wobei der Druck auf mindestens 7 bar ansteigt

Phase 4.2: Einstellen einer Mindesttemperatur oder eines Temperaturprofils für einen definierten Zeitraum, in dem ein Druck von mindestens 7 bar entsteht.

In einer bevorzugten Ausführungsform ist die Phase 5 wie folgt ausgestaltet:

Phase 5

Phase 5.1: Einstellung des Drucks im Reaktor B auf einen definierten Druck.

Phase 5.2: Einstellen des Reaktors B auf eine definierte Temperatur oder ein definiertes Temperaturprofil.

In einer bevorzugten Ausführungsform ist die Phase 6 wie folgt ausgestaltet:

Phase 6

Phase 6.1: Entfernen von im Zuge der Abscheidung gebildeten gasförmigen Reaktionsprodukten aus dem Reaktor B,

Phase 6.2: Transfer der Partikel in einen Reaktor C oder Zwischenlagerung in einen Vorratsbehälter E und anschließender Transfer in Reaktor C, oder das Material verbleibt im Reaktor B.

Phase 6.3: Einstellung von Reaktor C auf eine definierte Temperatur oder ein definiertes Temperaturprofil und einem definierten Druck

In einer bevorzugten Ausführungsform ist die Phase 7 wie folgt ausgestaltet:

Phase 7

Phase 7.1: Nachbehandlung der Partikel in Reaktor C zur Deaktivierung der Partikeloberflächen

Phase 7.2: Abkühlen der Partikel auf eine definierte Temperatur und Entnahme von Silicium enthaltenden Materialien aus Reaktor C, und vorzugsweise direkte Überführung in einen Vorratsbehälter E oder direkte Abfüllung in ein geeignetes Gebinde.

In Phase 1.1 werden poröse Partikel in einen beheizbaren und / oder vakuumfesten und / oder druckfesten Reaktor A befüllt, diese Befüllung kann manuell oder automatisch erfolgen.

Das Befüllen von Reaktor A mit porösen Partikeln kann beispielsweise unter Inertgasatmosphäre oder vorzugsweise Umgebungsluft durchgeführt werden. Als Inertgas können beispielsweise Wasserstoff, Helium, Neon, Argon, Krypton, Xenon, Stickstoff oder Kohlendioxid oder Gemische hiervon, wie beispielsweise Formiergas, eingesetzt werden. Bevorzugt sind Argon oder insbesondere Stickstoff.

Die automatische Befüllung kann zum Beispiels mittels Dosierschnecke, Zellenrad, Rüttelrinne, Tellerdosierer, Banddosierer, Vakuumdosiersystem, negativ Verwiegung oder sonstigem Dosiersystem aus zum Beispiel einem Silo, einer Sackschütte oder sonstigem Containersystem erfolgen.

Ziel der Vorbehandlung der Partikel in Reaktor A in Phase 1.2 ist die Entfernung von Luft bzw. Sauerstoff, Wasser oder von Dispergiermitteln, wie beispielsweise Tenside oder Alkohole, und Verunreinigungen aus den Partikeln. Dieses kann erreicht werden durch Inertisierung mit Inertgas, Erhöhung der Temperatur auf bis zu 1000 °C, Reduktion des Drucks auf bis zu 0,01 mbar oder einer Kombination der einzelnen Prozessschritte. Als Inertgas können beispielsweise Wasserstoff, Helium, Neon, Argon, Krypton, Xenon, Stickstoff oder Kohlendioxid oder Gemische hiervon, wie beispielsweise Formiergas, eingesetzt werden. Bevorzugt sind Argon oder insbesondere Stickstoff.

Ziel der Vorbehandlung in Phase 1.2 kann außerdem die Veränderung der chemischen Oberflächenbeschaffenheit der porösen Partikel mit weiteren Substanzen sein. Die Zugabe kann vor oder nach der Trocknung erfolgen und es kann ein weiterer Heizschritt erfolgen bevor das Material in Phase 1.3 transferiert wird. Die Substanzen können gasförmig, fest, flüssig oder als Lösung in den Reaktor gegeben werden, auch Mischungen, Emulsionen, Suspensionen, Aerosole oder Schäume sind möglich. Hierbei kann es sich beispielsweise um Kohlendioxid, Wasser, Natronlauge, Kalilauge, Flusssäure, Phosphorsäure, Salpetersäuere, Ammoniumdihydrogenphosphat, Lithiumnitrat, Natriumnitrat, Kaliumnitrat, Lithiumchlord, Natriumchlorid, Kaliumchlorid, Lithiumbromid, Natriumbromid, Kaliumbromid, Alkanolate handeln.

Der Transfer in Phase 1.3 kann beispielsweise durch ein Fallrohr, Stetigförderer Strömungsförderer/Saug- oder Druckförderanläse (z.B. Vakuumförderer, Transportgebläse); Mechanische Förderer (z.B. Rollenförderer mit Antrieb, Schneckenförderer, Kreisförderer, Umlaufförderer , Becherwerk, Zellenradschleusen, Kettenförderer, Kratzerförderer, Bandförderer, Schwingförderer); Schwerkraftförderer (z.B. Rutschen, Rollenbahn, Kugelbahn, Schienenbahn),sowie mittels Unstetigförderer Flurgebunden Schienenfrei (z.B. Automatikfahrzeug, Hand-Gabelhubwagen, Elektro-Gabelhubwagen, Fahrerlose Transportsysteme (FTS), Luftkissenfahrzeug, Handkarren, Elektrokarren, Motorfahrzeug (Schlepper, Wagen, Stapler), Verschiebewagen, Verschiebehubwagen, Regalbediengerät (ohne/mit Umsetzer, kurvengängig); Flurgebunden Schienengebunden (z.B. Betriebsbahn, Gleiswagen; Flurfrei (z.B Trolleybahn, Krane (z.B. Brückenkran, Portalkran, Auslegerkran, Turmkran), Elektrohängebahn (EHB), Kleinbehältertransportanlage; Stationär (z.B. Aufzug, Hebebühne und Hubarbeitsbühne Schrittförderer) erfolgen.

Der Vorratsbehälter D kann temperierbar, beweglich, isoliert, oder mit einem Rohrsystem mit Reaktor B verbunden sein.

In Phase 2.1 wird das vorbehandelte Material in Reaktor B vorzugsweise auf eine Temperatur von 100 bis 1000 °C gebracht, besonders bevorzugt 250 bis 500 °C und insbesondere bevorzugt 300 bis 400 °C.

In der optionalen Phase 2.2 wird Reaktor B vorzugsweise auf einen Druck von 0,01 mbar bis 100 bar eingestellt, besonders bevorzugt 0,01 mbar bis 10 bar und insbesondere bevorzugt 50 mbar bis 3 bar. Zur Einstellung des Druck können Inert- und / oder Reaktivgase eingesetzt werden. Als Inertgas können beispielsweise Wasserstoff, Helium, Neon, Argon, Krypton, Xenon, Stickstoff, Kohlendioxid oder Wasserdampf oder Gemische hiervon, wie beispielsweise Formiergas, eingesetzt werden. Bevorzugt sind Argon, Stickstoff oder insbesondere Wasserstoff.

Die Substanzen können gleichzeitig, beispielsweise über ein T-Stück oder eine vorgelagerte Mischbatterie, oder nacheinander in Reaktor B gegeben werden, wahlweise kann der Reaktor B vorher evakuiert werden.

Vorzugsweise wird der Reaktor B in Phase 2.2 zunächst, also insbesondere vor Beaufschlagen des Reaktors B mit Reaktivkomponente in Phase 2.3 und / oder 2.4, mit Inertgas beaufschlagt oder evakuiert.

In der optionalen Phase 2.3 wird der Reaktor B mit einer Reaktivkomponente, die keinen Silicium-Präkursor enthält, beaufschlagt.

In Phase 2.4 wird der Reaktor B mit einer Reaktivkomponente enthaltend zumindest einen Silicium-Präkursor beaufschlagt.

In einer Variante des Verfahrens wird die Reaktivkomponente direkt in die Schüttung aus porösen Partikeln in den Reaktor gegeben, beispielsweise von unten oder über einen speziellen Rührer. Besonders bevorzugt ist diese Variante bei einer Dosierung in einen Reaktor B bei einem Druck unter 1 bar vor dem Start der Zugabe.

Der Reaktor B wird vorzugsweise mit einer solchen Menge an Reaktivkomponente beaufschlagt, dass in Bezug auf die eingewogene Menge poröser Partikel eine für die Zielkapazität des herzustellenden Silicium enthaltenden Materials ausreichende Menge Silicium abgeschieden wird. Dieses kann in einem Schritt oder in mehreren Iterationen der Phasen 2.1 bis 6.1 erfolgen.

Beaufschlagen bedeutet allgemein das Einbringen der Reaktivkomponente in die Reaktoren. Während des Einbringens in die Reaktoren können die Bestandteile der Reaktivkomponente beispielsweise in gasförmiger, flüssiger oder sublimierbarer fester Form vorliegen.

Die Reaktivkomponente ist bevorzugt gasförmig, flüssig, fest, beispielsweise sublimierbar, oder eine Stoffmischung gegebenenfalls bestehend aus Stoffen in verschiedenen Aggregatzuständen.

Die Reaktivkomponente aus Phase 2.4 enthält zumindest einen Silicium-Präkursor und gegebenenfalls einen Inertgasbestandteil. Der eine oder die mehreren Silicium-Präkursoren können allgemein gemischt oder getrennt oder in Mischung mit Inertgasbestandteilen oder als Reinstoffe in Reaktor B eingebracht werden. Bevorzugt enthält die Reaktivkomponente einen Inertgasbestandteil von 0 bis 99%, besonders bevorzugt höchstens 50%, insbesondere bevorzugt höchstens 30% und ganz besonders bevorzugt höchstens 5%, bezogen auf den Partialdruck des Inertgasbestandteils am Gesamtdruck der Reaktivkomponente unter Normbedingungen (nach DIN 1343). In einer besonders bevorzugten Ausführungsform enthält die Reaktivkomponente keinen Inertgasbestandteil.

Der Silicium-Präkursor enthält mindestens eine Reaktivkomponente, welche unter den gewählten Bedingungen, beispielsweise thermischer Behandlung, zu Silicium reagieren kann. Die Reaktivkomponente wird bevorzugt aus der Gruppe ausgewählt enthaltend Silicium-Wasserstoff-Verbindungen wie Monosilan $SiH_4$, Disilan $Si_2H_6$ sowie höhere lineare, verzweigte oder auch zyklische Homologe, neo-Pentasilan $Si_5H_{12}$, cyclo-Hexasilan $Si_6H_{12}$, Chlorhaltige Silane, wie beispielsweise Trichlorsilan $HSiCl_3$, Dichlorsilan $H_2SiCl_2$, Chlorsilan $H_3SiCl$, Tetrachlorsilan $SiCl_4$, Hexachlordisilan $Si_2Cl_6$, sowie höhere lineare, verzweigte oder auch cyclische Homologe wie beispielsweise 1,1,2,2-Tetrachlordisilan $Cl_2HSi-SiHCl_2$, chlorierte und teilchlorierte Oligo- und Polysilane, Methylchlorsilane, wie beispielsweise Trichlormethylsilan $MeSiCl_3$, Dichlordimethylsilan $Me_2SiCl_2$, Chlortrimethylsilan $Me_3SiCl$, Tetramethylsilan $Me_4Si$, Dichlormethylsilan $MeHSiCl_2$, Chlormethylsilan $MeH_2SiCl$, Methylsilan $MeH_3Si$, Chlordimethylsilan $Me_2HSiCl$, Dimethylsilan $Me_2H_2Si$, Trimethylsilan $Me_3SiH$ oder auch Mischungen aus den beschriebenen Siliciumverbindungen.

In einer speziellen Ausführungsform des Verfahrens wird das Monosilan oder Mischungen aus Silanen wie z.B. Mischungen aus Monosilan $SiH_4$, Trichlorsilan $HSiCl_3$, Dichlorsilan $H_2SiCl_2$, Monochlorsilan $H_3SiCl$ und Tetrachlorsilan $SiCl_4$, wobei jeder Bestandteil von 0 bis 99,9 Gew.-% vorliegen kann, erst mit einem geeigneten Verfahren direkt vor dem Einsatz im Reaktor hergestellt. In der Regel gehen diese Verfahren von Trichlorsilan $HSiCl_3$ aus, das an einem geeigneten Katalysator (z.B. AmberLyst™ A21DRY) zu den anderen Komponenten der beschriebenen Mischung umgelagert wird. Die Zusammensetzung der entstehenden Mischung wird hauptsächlich durch die Aufarbeitung der, nach ein oder mehreren Umlagerungsstufen, bei einer oder mehreren unterschiedlichen Temperaturen, entstandene Mischung bestimmt.

Besonders bevorzugte Reaktivkomponenten werden ausgewählt aus der Gruppe umfassend Monosilan $SiH_4$, oligomere oder polymere Silane, insbesondere lineare Silane der allgemeinen Formel $Si_nH_{n+2}$, wobei n eine ganze Zahl im Bereich 2 bis 10 umfassen kann sowie cyclische Silane der allgemeinen Formel $-[SiH_2]_n-$, wobei n eine ganze Zahl im Bereich 3 bis 10 umfassen kann, Trichlorsilan $HSiCl_3$, Dichlorsilan $H_2SiCl_2$ sowie Chlorsilan $H_3SiCl$, wobei diese allein oder auch als Mischungen zum Einsatz kommen können, ganz besonders bevorzugt kommen $SiH_4$, $HSiCl_3$ und $H_2SiCl_2$ allein oder in Mischung zum Einsatz.

Darüber hinaus können die Reaktivkomponenten aus Phase 2.3 und / oder 2.4 zusätzlich auch weitere reaktive Bestandteile enthalten, wie Dotierstoffe beispielsweise auf Basis von Bor, Stickstoff, Phosphor, Arsen, Germanium, Eisen oder auch Nickel enthaltender Verbindungen. Die Dotierstoffe werden bevorzugt ausgewählt aus der Gruppe umfassend Ammoniak $NH_3$, Diboran $B_2H_6$, Phosphan $PH_3$, German $GeH_4$, Arsan $AsH_3$, Eisenpentacarbonyl $Fe(CO)_4$ und Nickeltetracarbonyl $Ni(CO)_4$.

Weitere reaktive Bestandteile, die in der Reaktivkomponente enthalten sein können, umfassen Wasserstoff oder auch Kohlenwasserstoffe, ausgewählt aus der Gruppe enthaltend aliphatische Kohlenwasserstoffe mit 1 bis 10 Kohlenstoffatomen, bevorzugt 1 bis 6 Kohlenstoffatomen, wie beispielsweise Methan, Ethan, Propan, Butan, Pentan, Isobutan, Hexan, Cyclopropan, Cyclobutan, Cyclopentan, Cyclohexan, Cycloheptan; ungesättigte Kohlenwasserstoffe mit 1 bis 10 Kohlenstoffatomen wie beispielsweise Ethen, Acetylen, Propen oder Buten, Isopren, Butadien, Divinylbenzol, Vinylacetylen, Cyclohexadien, Cyclooctadien, zyklische ungesättigte Kohlenwasserstoffe, wie beispielsweise Cyclopropen, Cyclobuten, Cyclopenten, Cyclohexen, Cyclohexadien, Cyclopentadien, Dicyclopentadien oder Norbornadien, aromatische Kohlenwasserstoffe, wie beispielsweise Benzol, Toluol, p-,m-,o-Xylol, Styrol (Vinylbenzol), Ethylbenzol, Diphenylmethan oder Naphthalin, weitere aromatische Kohlenwasserstoffe, wie beispielsweise Phenol, o-, m-, p-Kresol, Cymol, Nitrobenzol, Chlorbenzol, Pyridin, Anthracen oder Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, wie beispielsweise aus Erdgaskondensaten, Erdöldestillaten oder Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

Phasen 2.1, 2.2, 2.3 und 2.4 können, müssen aber nicht in der Reihenfolge ihrer Nummerierung erfolgen. Sie können auch mehrmals hintereinander in beliebiger Reihenfolge durchgeführt werden.

In Phase 3.1, also allgemein nach Beaufschlagen des Reaktor B mit der Reaktivkomponente entsprechend Phase 2.4, wird der Reaktor B bis zum Erreichen der Zieltemperatur aufgeheizt. Bei der Zieltemperatur beginnt die Zersetzung des Silicium-Präkursors unter Abscheidung von Silicium in Poren und auf der Oberfläche der porösen Partikel. Der Beginn der Zersetzung von Silicium-Präkursoren unter Abscheidung von Silicium kann experimentell durch einen Druckanstieg in Reaktor B festgestellt werden, der nicht durch eine Temperaturerhöhung in Reaktor B bewirkt wird. Bei der Zersetzung von Silicium-Präkursoren entstehen neben Silicium unter Reaktionsbedingungen allgemein gasförmige Moleküle, wodurch eine Zunahme des Drucks in Reaktor B bewirkt wird. Das Volumen von Reaktor B bleibt während der Durchführung des Verfahrens allgemein konstant.

Vorzugsweise hängt in Phase 3.1 die Druckänderung dp beim Aufheizen des geschlossenen Reaktor B mit dem Volumen V im Wesentlichen von der Temperaturänderung dT ab, was beispielsweise durch die thermodynamische Zustandsgleichung gemäß Gleichung 1 beschrieben werden kann:

$$\mathrm{d}p_{\text{Phase 3}} = \left(\frac{\partial p}{\partial T}\right)_{V,n} \mathrm{d}T \qquad\qquad (1)$$

Nach Erreichen der Zieltemperatur für die Zersetzung des Silicium-Präkursors in Phase 3.2 kann in Phase 4.1 die Temperatur in Reaktor B in Relation zu der Zieltemperatur von Phase 3.1 beispielsweise erhöht, konstant gehalten oder im geringen Umfang gesenkt werden.

Die Temperatur, der Druck oder Differenzdruckmessungen in Reaktor B in alle Phasen können mit für Reaktoren gängigen Messgeräten und Messmethoden bestimmt werden. Nach üblicher Kalibrierung ergeben unterschiedliche Messgeräte dieselben Messergebnisse.

Die Zieltemperatur liegt vorzugsweise im Bereich von 250 bis 1000°C, besonders bevorzugt 300 bis 800°C und am meisten bevorzugt 300 bis 550°C. Beispielsweise liegen die Zieltemperaturen für $SiH_4$ bevorzugt zwischen 300 und 500°C, besonders bevorzugt im Bereich von 320 bis 450°C und ganz besonders bevorzugt im Bereich von 320 bis 420°C. Die Zieltemperaturen für $HSiCl_3$ liegen bevorzugt zwischen 380 und 1000°C, besonders bevorzugt im Bereich 420 bis 600°C. Die Zieltemperaturen für $H_2SiCl_2$ liegen bevorzugt zwischen 350 und 800°C, besonders bevorzugt im Bereich 380 bis 500°C.

Im Falle des Einsatzes von Kohlenwasserstoffen in Phase 2.3 als weitere Reaktivkomponenten, die keinen Silicium-Präkursor enthalten, werden in der Phase 3.2 und / oder zusätzlich zur Siliciumabscheidung während der Phase 4.1 und 4.2 Zieltemperaturen angewendet, bei denen die Zersetzung der Kohlenwasserstoffe beginnt und Kohlenstoff in Poren und auf der Oberfläche der porösen Partikel abgeschieden wird. Vorzugsweise werden die Zieltemperaturen in dieser Ausführungsform im Bereich von 250 bis 1000°C, besonders bevorzugt von 350 bis 850°C und am meisten bevorzugt von 400 bis 650°C gewählt.

Im erfindungsgemäßen Verfahren steigt der Druck in Reaktor B während Phasen 4.1 und 4.2 auf mindestens 7 bar.

In einer bevorzugten Ausführungsform wird der Reaktionsfortschritt im Laufe des Verfahrens anhand von Druckänderungen verfolgt. Damit kann beispielsweise der Infiltrationsgrad oder das Ende der Infiltration ermittelt werden. Infiltration bezeichnet die Abscheidung von Silicium in Poren und auf der Oberfläche der porösen Partikel in Phase 4.1 und 4.2. Das Ende der Infiltration kann beispielsweise am Ausbleiben eines weiteren Druckanstiegs festgestellt werden.

Die Druckänderung dp in Reaktor B mit dem Volumen V während Phasen 4.1 und 4.2 ergibt sich allgemein im Wesentlichen aus der Temperaturänderung dT und/oder Stoffmengenänderung $dn_i$ im Zuge der Abscheidung von Silicium, was beispielweise durch Gleichung 2 abgebildet wird:

$$\mathrm{d}p_{\text{Phase 4}} = \left(\frac{\partial p}{\partial T}\right)_{V,n_i} \mathrm{d}T + \sum_{i,i\neq j}\left(\frac{\partial p}{\partial n_i}\right)_{V,T,n_j} \mathrm{d}n_i \qquad\qquad (2)$$

Die Druckänderung in Phasen 4.1 und 4.2 ergibt sich vorzugsweise im Wesentlichen durch die Stoffmengenänderung im Zuge der Abscheidung von Silicium. Vorteilhafterweise kann das Ende der Reaktion der Silicium-Präkursoren somit am Ausbleiben eines weiteren Druckanstiegs am Ende der Phasen 4.1 und 4.2 erkannt werden, so dass die weiteren Phasen zeitlich effektiv ausgelöst werden können, ohne dass nicht umgesetzte Silicium-Präkursoren unnötig aus dem Reaktor entfernt werden und eine vollständige Umsetzung erzielt wird.

In einer Variante des Verfahrens wird in Phasen 4.1 und 4.2 die Temperatur nicht durch eine externe Heizung erhöht oder gehalten. Die Temperatur in Phase 4.1 und 4.2 stellt sich bevorzugt durch die entstehende Wärme der gegebenenfalls exothermen Zersetzung der Silicium-Präkursoren ein. Weiterhin bevorzugt ist ein leichter Temperaturabfall in Phasen 4.1 und 4.2, besonders bevorzugt von maximal 20°C während Phase 4.1 und 4.2.

Vorzugsweise ist der Druckanstieg dp in Reaktor B in der Phase 4.1 und 4.2 (Zersetzung des Silicium-Präkursors) höher als in der Phase 3.1 (Aufheizen des druckfesten Reaktors), was beispielsweise durch Gleichung 3a oder 3b abgebildet wird:

$$dp_{\text{Phase 4}} > dp_{\text{Phase 3}} \qquad (3a),$$

oder

$$\left[\left(\frac{\partial p}{\partial T}\right)_{V,n_i} dT + \sum_{i,i\neq j}\left(\frac{\partial p}{\partial n_i}\right)_{V,T,n_j} dn_i\right]_{\text{Phase 4}} > \left[\left(\frac{\partial p}{\partial T}\right)_{V,n} dT\right]_{\text{Phase 3}} \qquad (3b).$$

Bevorzugt erreicht der Druck in Reaktor B in der Phase 4.1 und 4.2 zumindest 10 bar, besonders bevorzugt zumindest 50 bar und besonders bevorzugt zumindest 100 bar. Bevorzugt bleibt der Druck in Reaktor B in Phase 4.1 und 4.2 unterhalb 400 bar, besonders bevorzugt unterhalb 300 bar und insbesondere bevorzugt bei unterhalb 200 bar.

In Reaktor B herrscht in Phase 4.1 und 4.2 eine Temperatur im Bereich von bevorzugt 100 bis 1000°C, besonders bevorzugt im Bereich von 300 bis 900°C und am meisten bevorzugt im Bereich von 320 bis 750°C.

Die Temperatur, der Druck, Druckänderungen oder Differenzdruckmessungen in Reaktor B in Phase 4.1 und 4.2 können mit für druckfeste Reaktoren gängigen Messgeräten und Messmethoden bestimmt werden. Nach üblicher Kalibrierung ergeben unterschiedliche Messgeräte dieselben Messergebnisse. Stoffmengen oder Stoffmengenänderungen können beispielsweise bestimmt werden, indem dem druckfesten Reaktor eine Probe definierten Volumens entnommen und deren stoffliche Zusammensetzung auf herkömmliche Weise mittels Gaschromatographie bestimmt wird.

Das Aufheizen von Reaktor B in Phase 3.1 und gegebenenfalls in Phase 4.1 kann beispielsweise mit einer konstanten Heizrate oder mit mehreren unterschiedlichen Heizraten erfolgen. Heizraten können vom Fachmann im Einzelfall je nach Ausgestaltung des Verfahrens angepasst werden, beispielsweise je nach Größe des Reaktors, der Menge der porösen Partikel im Reaktor, der Rührtechnologie, der geplanten Reaktionszeit. Bevorzugt wird der gesamte Reaktor B in Phase 3.1 so schnell aufgeheizt, dass trotz der schnellen Aufheizung der maximale Temperaturgradient in Reaktor B bei einer Temperatur, bei der die Zersetzung des Silicium-Präkursors beginnt, unterhalb von 1000°C/m, besonders bevorzugt unterhalb 100°C/m und ganz besonders bevorzugt unterhalb 10°C/m bleibt. Damit kann beispielsweise erreicht werden, dass der überwiegende Teil des Siliciums in den Poren der porösen Partikel und nicht auf deren äußeren Oberflächen abgeschieden wird.

Die Temperatur, bei der die Zersetzung des Silicium-Präkursors beginnt, kann beispielsweise von den eingesetzten porösen Partikeln, dem oder den eingesetzten Silicium-Präkursoren und den anderen Randbedingungen der Zersetzung, wie beispielsweise dem Partialdruck des Silicium-Präkursors zum Zeitpunkt der Zersetzung und der Anwesenheit von anderen Reaktivkomponenten, wie beispielsweise Katalysatoren, die die Zersetzungsreaktion beeinflussen, abhängen.

Bevorzugt erfolgt das Aufheizen von Reaktor B in Phase 3.1 mit Heizraten von 1 bis 100°C pro Minute, besonders bevorzugt mit Heizraten 2 bis 50°C pro Minute, ganz besonders bevorzugt mit einer Heizrate von 3 bis 10°C pro Minute.

Während der Zersetzung der Silicium-Präkursoren in Phase 4.1 und 4.2 kann die Temperatur konstant gehalten oder auch variiert werden. Ziel ist der weitgehend vollständige Umsatz der Silicium-Präkursoren in möglichst kurzer Zeit unter Erzeugung eines für die Anwendung geeigneten Silicium enthaltenden Materials.

Um die Geschwindigkeit des Druckanstieges in den verschiedenen Phasen des Prozesses zu kontrollieren, können verschiedene technische Lösungen eingesetzt werden. Um den Druckanstieg zu steigern oder zu reduzieren, wird vorzugsweise die Wärmezufuhr zum Reaktorinhalt gesteigert beziehungsweise reduziert. Um die Druckanstiegsgeschwindigkeit zu reduzieren, wird vorzugsweise auch die Wärmeabfuhr aus Reaktor B und C durch Kühlung gesteigert; dazu werden vorzugsweise eine oder mehrere Reaktorwände gekühlt oder in den Reaktor Einrichtungen zur Wärmeabfuhr, beispielsweise Kühlrohre oder Kühlrippen, eingebracht. Um den Druck im Reaktor sehr schnell zu kontrollieren, ist die Zufuhr oder Abfuhr von geringen Gasmengen aus Reaktor B oder C oder die Zufuhr von verdampfenden Flüssigkeiten bevorzugt. Dabei wird der aus Reaktor B oder C abgeführte Teilstrom nach Abkühlung und/oder Abtrennung eines Teils des Gesamtstromes in den Reaktorinhalt in einem geschlossenen Kreislauf bevorzugt wieder ganz oder teilweise zurückgeführt.

Der Verlauf der Reaktion in Phasen 4.1 und 4.2 wird bevorzugt analytisch verfolgt, um das Ende der Reaktion zu erkennen und so die Reaktorbelegungszeit möglichst gering zu halten. Verfahren zur Beobachtung des Reaktionsverlaufs umfassen dabei beispielsweise Temperaturmessung zum Feststellen einer Exo- oder Endothermie, Druckmessungen zur Feststellung des Reaktionsverlaufs durch sich ändernde Verhältnisse von festen zu gasförmigen Reaktorinhaltsbestandteilen sowie durch weitere Methoden, die die Beobachtung der sich verändernden Zusammensetzung des Gasraums während der Reaktion ermöglichen.

Vorzugsweise wird die Änderung des Drucks, insbesondere die Steigung des Drucks, in Reaktor B während der Durchführung des Verfahrens verfolgt. Die Steigung ist ein Indikator für die Abscheidegeschwindigkeit und somit ein Hinweis auf die verbleibende Oberfläche in den porösen Partikeln beziehungsweise im entstehenden Silicium enthaltenden Material.

In einer weiteren bevorzugten Variante des Verfahrens kommt ein technisches Bauteil zum Einsatz das die Trennung von Wasserstoff und Silan ermöglicht. Diese Trennung kann beispielsweise über Filtration bzw. Membranverfahren (Lösungs-Diffusions- und Hydrodynamisches Modell), Adsorption, Chemisorption, Absorption bzw. Chemisorption oder Molsiebe (z.B. Zeolith) erfolgen. Dieses Bauteil ermöglicht, im Fall von Wasserstoff als gasförmigen Reaktionsprodukt, dass Phase 2.4 kontinuierlich fortgesetzt werden kann bis die gewünschte Menge Silicium abgeschieden wurde. Ebenso wird Phase 6.1 parallel kontinuierlich fortgesetzt.

In einer weiteren bevorzugten Variante des Verfahrens ist der Reaktor B mir einer technischen Möglichkeit ausgestattet die zur Entfernung von auftretenden, kondensierbaren oder resublimierbaren Nebenprodukten dient. In einer besonders bevorzugten Variante wird hierbei Siliciumtetrachlorid kondensiert und separat vom Silicium enthaltenden Material entfernt.

In Phase 5.1 wird der Druck in Reaktor B durch Ablassen des vorhandenen Drucks, Evakuieren und / oder Beaufschlagung mit einem weiteren Gas eingestellt, bevorzugt sind Inertgase, wie beispielsweise Wasserstoff, Helium, Neon, Argon, Krypton, Xenon, Stickstoff, Kohlendioxid oder Wasserdampf einzeln oder als Gemische, besonders bevorzugt ist Wasserstoff.

In Phase 5.2 wird Reaktor B auf eine definierte Temperatur eingestellt oder ein definiertes Temperaturprofil durchlaufen. Vorzugsweise wird nach Beendigung der Abscheidung optional auf eine Zieltemperatur abgekühlt, vorzugsweise auf die Temperatur für eine erneute Phase 2.3 und / oder 2.4 gebracht.

Die Reihenfolge von 5.1 und 5.2 ist beliebig wählbar. Phase 5.1 und 5.2 können sich in ihrem Ablauf zeitlich überschneiden.

In Phase 6.1 werden die im Zuge der Abscheidung gebildeten gasförmigen Reaktionsnebenprodukte vorzugsweise bei der Temperatur der Abscheidung oder nach Erreichen der für das Entfernen der gasförmigen Reaktionsnebenprodukte gewünschten Temperatur aus dem Gasraum von Reaktor B entfernt, beispielsweise gespült. Vorzugsweise wird ein Spülgas verwendet. Vorzugsweise wird Reaktor B vor Beaufschlagung mit dem Spülgas zumindest einmal evakuiert. Bevorzugte Spülgase sind Inertgase, wie beispielsweise Wasserstoff, Helium, Neon, Argon, Krypton, Xenon, Stickstoff, Kohlendioxid oder Wasserdampf einzeln oder als Gemische oder deren Mischungen mit Sauerstoff, wie beispielsweise Luft oder Magerluft, zum Einsatz. Der Wassergehalt der Gasmischung kann hierbei eingestellt werden. In Phase 6.2 werden die erhaltenen Partikel aus Reaktor B dann entweder in einen Reaktor C oder in einen geeigneten Vorratsbehälter überführt. Wurden die Partikel in einen Vorratsbehälter überführt, so können die Partikel direkt von diesem in Reaktor C überführt werden. Der Transfer in Phase 6.2 kann beispielsweise durch ein Fallrohr, Stetigförderer Strömungsförderer/Saug- oder Druckförderanlage (z.B. Vakuumförderer, Transportgebläse); Mechanische Förderer (z.B. Rollenförderer mit Antrieb, Schneckenförderer, Kreisförderer, Umlaufförderer , Becherwerk, Zellenradschleusen, Kettenförderer, Kratzerförderer, Bandförderer, Schwingförderer); Schwerkraftförderer (z.B. Rutschen, Rollenbahn, Kugelbahn, Schienenbahn), sowie mittels Unstetigförderer Flurgebunden Schienenfrei (z.B. Automatikfahrzeug, Hand-Gabelhubwagen, Elektro-Gabelhubwagen, Fahrerlose Transportsysteme (FTS), Luftkissenfahrzeug, Handkarren, Elektrokarren, Motorfahrzeug (Schlepper, Wagen, Stapler), Verschiebewagen, Verschiebehubwagen, Regalbediengerät (ohne/mit Umsetzer, kurvengängig); Flurgebunden Schienengebunden (z.B. Betriebsbahn, Gleiswagen; Flurfrei (z.B Trolleybahn, Krane (z.B. Brückenkran, Portalkran, Auslegerkran, Turmkran), Elektrohängebahn (EHB), Kleinbehältertransportanlage; Stationär (z.B. Aufzug, Hebebühne und Hubarbeitsbühne Schrittförderer, erfolgen.

In Phase 7.1 des Verfahrens können die Silicium enthaltenden Partikel in Reaktor C nachbehandelt und / oder deaktiviert werden. Vorzugsweise wird hierzu Reaktor C mit Sauerstoff, insbesondere mit einem Gemisch aus Inertgas und Sauerstoff gespült. Dadurch kann beispielsweise die Oberfläche des Silicium enthaltenden Materials modifiziert und / oder deaktiviert werden. Beispielsweise kann eine Reaktion etwaiger auf der Oberfläche des Silicium enthaltenden Materials vorhandener, reaktiver Gruppen erreicht werden. Bevorzugt wird dazu eine Mischung von Stickstoff, Sauerstoff und gegebenenfalls Alkohole und/oder Wasser eingesetzt, die bevorzugt höchstens 20 Vol.-%, besonders bevorzugt höchstens 10 Vol.-% und insbesondere bevorzugt höchstens 5 Vol.-% Sauerstoff, sowie bevorzugt höchstens 100 Vol.-%, besonders bevorzugt höchstens 10 Vol.-% und insbesondere bevorzugt höchstens 1 Vol.-% Wasser enthält. Dieser Schritt erfolgt bevorzugt bei Temperaturen von höchstens 200°C, besonders bevorzugt höchstens 100°C und insbesondere bevorzugt bei höchstens 50°C. Die Deaktivierung der Partikeloberflächen kann auch mit einem Gasgemisch, enthaltend Inertgas und Alkohole erfolgen. Bevorzugt werden hier Stickstoff und Isopropanol eingesetzt. Es können aber auch Methanol, Ethanol, Butanole, Pentanole oder langkettigere und verzweigte Alkohole und Diole eingesetzt werden.

Die Deaktivierung der Partikel kann auch durch Dispergierung in einem flüssigen Lösemittel oder ein Lösemittelgemisch erfolgen. Dieses kann beispielsweise Isopropanol oder eine wässrige Lösung enthalten.

Wahlweise kann die Deaktivierung der Partikel in Phase 7.1 auch über eine Beschichtung mittels C-, Al-, B-haltiger Präkursoren bei Temperaturen von 200-800°C und optional anschließender Behandlung mit Sauerstoff-haltiger Atmosphäre erfolgen.

Als Aluminium-haltige Präkursoren können beispielsweise Trimethylaluminium ($(CH_3)_3Al$), Aluminium-2,2,6,6-tetramethyl-3,5-heptandionat ($Al(OCC(CH_3)_3CHCOC(CH_3)_3)_3$), Tris-(dimethylamido)-aluminium ($Al(N(CH_3)_2)_3$) und

EP 4 377 259 B1

Aluminiumtriisopropanolat ($C_9H_{21}AlO_3$) eingesetzt werden.

Als Bor-haltige Präkursoren können beispielsweise Boran ($BH_3$), Triisopropylborat ($[(CH_3)_2CHO]_3B$), Triphenylboran ($(C_6H_5)_3B$) und Tris-(pentafluorophenyl)-boran ($(C_6F_5)_3B$) eingesetzt werden.

In Phase 7.1 können aber auch beispielsweise Nachbeschichtungen der Partikel mit Festkörperelektrolyten über CVI-Abscheidungen aus beispielsweise Tert-Butyllithium und Trimethylphosphat eingeführt werden.

In Phase 7.2 des Verfahrens werden grundsätzlich die Silicium enthaltende Materialien, gegebenenfalls unter Erhalt einer in Reaktor C vorhandenen Inertgasatmosphäre, aus Reaktor C entnommen. Dies kann beispielsweise über folgende Austragsverfahren erfolgen; pneumatisch (mittels Über- oder Unterdruck); mechanisch (Zellenradschleuse, Telleraustrag, Austragsschnecke bzw. Rührorgan im Reaktor, Bandaustrag), gravimetrisch (Doppelklappe bzw. -kugelhahn ggf. unterstützt durch Vibration)

In einer weiteren bevorzugten Ausführungsform des Verfahrens werden die Phasen 2.1 bis 5.2 einmal oder mehrfach wiederholt.

In einer bevorzugten Ausführungsform des Verfahrens werden die Phasen 2.1 bis 5.2 mehrfach wiederholt, wobei der jeweils in Phase 2.4 beaufschlagte Silicium-Präkursor jeweils gleich oder unterschiedlich sein kann, wobei auch Mischungen aus mehreren Silicium-Präkursoren möglich sind. Ebenfalls kann die in 2.3 beaufschlagte Reaktivkomponente jeweils gleich oder unterschiedlich sein oder aus Mischungen verschiedener Reaktivkomponenten bestehen. Nach der mehrfachen Wiederholung der einzelnen Phasen 2.1 bis 5.2, wird die Durchführung in Reaktor B mit der Phase 6 beendet. Die Reihenfolge und die Durchführung der Phasen 2.1 bis 6.1 kann vom Fachmann variiert werden. Hierbei können einzelne Phasen ausgelassen werden.

In einer weiteren bevorzugten Ausführungsform des Verfahrens folgt Phase 6.1 unmittelbar auf Phase 4.2; das heißt auf Phase 5 kann verzichtet werden; das heißt nach Phase 4.2 kann auch ohne Abkühlen des Reaktor B mit Phase 6.1 fortgefahren werden.

In einer weiteren bevorzugten Ausführungsform werden die Phasen 2.1 bis 6.1, gegebenenfalls unter Verzicht auf Phase 5, (Reaktionszyklus) einmal oder mehrfach wiederholt, wobei in einzelnen oder mehreren Wiederholungen auch Silicium-freie Reaktivkomponenten im Sinne von Phase 2.3 zum Einsatz kommen können, wobei die Silicium-freien Reaktivkomponenten in den jeweiligen Wiederholungen gleich oder verschieden sein können. Silicium-freie Reaktivkomponenten enthalten vorzugsweise keinen Silicium-Präkursor. Silicium-freie Reaktivkomponenten enthalten vorzugsweise einen oder mehrere Kohlenwasserstoffe. In dieser bevorzugten Ausführungsform kann der Einsatz der Silicium-freien Reaktivkomponente in einer Wiederholung der Phasen 2.1 bis 6.1 beispielsweise vor oder nach der Abscheidung von Silicium oder auch zwischen zwei Abscheidungen von Silicium erfolgen. Bevorzugte Silicium-freie Reaktivkomponenten sind Kohlenwasserstoffe. Vorzugsweise wird bei Einsatz von Silicium-freien Reaktivkomponenten Kohlenstoff in Poren und auf der Oberfläche der porösen Partikel oder der Silicium enthaltenden Materialien abgeschieden.

In einer besonders bevorzugten Ausführungsform wird in einem ersten Reaktionszyklus in Phase 2.4 eine Reaktivkomponente enthaltend zumindest einen Silicium-Präkursor beaufschlagt und im zweiten Reaktionszyklus in Phase 2.3 eine zumindest einen Kohlenwasserstoff enthaltende Reaktivkomponente beaufschlagt, welche vorzugweise Silicium-frei ist, wobei gegebenenfalls auf Phase 5 verzichtet wird. Dadurch kann beispielsweise ein Silicium enthaltendes Material erhalten werden, welches keine nach außen gerichtete freie Siliciumoberfläche aufweist. Die Reihenfolge von 2.3 und 2.4 ist variabel.

Optional wird in einem dritten Reaktionszyklus in Phase 2.3 eine weitere Kohlenwasserstoff-haltige Silicium-freie Reaktivkomponente eingesetzt, wobei gegebenenfalls auf Phase 5 verzichtet wird. Dadurch wird beispielsweise ein Silicium enthaltendes Material erhältlich, welches zwischen den porösen Partikeln und dem abgeschiedenen Silicium eine Kohlenstoffschicht aufweist und welches gegebenenfalls zusätzlich eine äußere Kohlenstoffschicht trägt, wodurch keine nach außen gerichtete freie Siliciumoberfläche vorhanden ist.

Als Silicium-freie Reaktivkomponente sind ein oder mehrere Kohlenwasserstoffe bevorzugt. Durch thermische Zersetzung der Kohlenwasserstoffe kann allgemein Kohlenstoff in Poren und auf der Oberfläche der porösen Partikel abgeschieden werden. Beispiele für Kohlenwasserstoffe sind aliphatische Kohlenwasserstoffe mit 1 bis 10 Kohlenstoffatomen, insbesondere 1 bis 6 Kohlenstoffatomen, vorzugsweise Methan, Ethan, Propan, Butan, Pentan, Isobutan, Hexan, Cyclopropan, Cyclobutan, Cyclopentan, Cyclohexan und Cycloheptan, ungesättigte Kohlenwasserstoffe mit 1 bis 10 Kohlenstoffatomen, wie beispielsweise Ethen, Acetylen, Propen oder Buten, Isopren, Butadien, Divinylbenzol, Vinylacetylen, Cyclohexadien, Cyclooctadien, cyclische ungesättigte Kohlenwasserstoffe, wie beispielsweise Cyclopropen, Cyclobuten, Cyclopenten, Cyclohexen, Cyclohexadien, Cyclopentadien, Dicyclopentadien und Norbornadien, aromatische Kohlenwasserstoffe, wie beispielweise Benzol, Toluol, p-,m-,o-Xylol, Styrol (Vinylbenzol), Ethylbenzol, Diphenylmethan und Naphthalin, weitere aromatische Kohlenwasserstoffe, wie beispielsweise Phenol, o-, m-, p-Kresol, Cymol, Nitrobenzol, Chlorbenzol, Pyridin, Anthracen und Phenanthren, Myrcen, Geraniol, Thioterpineol, Norbornan, Borneol, iso-Borneol, Bornan, Campher, Limonen, Terpinen, Pinen, Pinan, Caren, Phenol, Anilin, Anisol, Furan, Furfural, Furfurylalkohol, Hydroxymethylfurfural, Bishydroxymethylfuran und gemischte Fraktionen, die eine Vielzahl solcher Verbindungen enthalten, wie beispielsweise aus Erdgaskondensaten, Erdöldestillaten oder Koksofenkondensaten, gemischte Fraktionen aus den Produktströmen eines Fluid-Catalytic-Crackers (FCC), Steam-Crackers oder einer Fischer-Tropsch-Syntheseanlage, oder ganz allgemein kohlenwasserstoffhaltige Stoffströme aus der Holz-, Erdgas-, Erdöl- und Kohleverarbeitung.

Die Silicium-freien Reaktivkomponenten, nämlich die Reaktivkomponenten, die ein oder mehrere Kohlenwasserstoffe aber keinen Silicium-Präkursor enthalten, enthalten vorzugsweise keine weitere Komponente oder ein oder mehrere Inertgase und/oder ein oder mehrere reaktive Bestandteile, wie beispielsweise Wasserstoff, und/oder ein oder mehrere Dotierstoffe. Dotierstoffe sind beispielsweise Bor, Stickstoff, Phosphor, Arsen, Germanium, Eisen oder Nickel enthaltende Verbindungen. Die Dotierstoffe werden bevorzugt ausgewählt aus der Gruppe umfassend Ammoniak $NH_3$, Diboran $B_2H_6$, Phosphan $PH_3$, German $GeH_4$, Arsan $AsH_3$ und Nickeltetracarbonyl $Ni(CO)_4$.

Ein temperierbarer Reaktor ist allgemein ein Reaktor, der so betrieben werden kann, dass die Temperatur im Inneren des Reaktors beispielweise im Bereich zwischen -40 und 1000 °C eingestellt werden kann. Kleinere Temperaturbereiche sind möglich.

Ein vakuumfester Reaktor ist allgemein ein Reaktor, der so betrieben werden kann, dass der Druck im Inneren des Reaktors kleiner / gleich ist als der Umgebungsdruck des Reaktors.

Ein druckfester Reaktor ist allgemein ein Reaktor, der so betrieben werden kann, dass der Druck im Inneren des Reaktors größer / gleich ist als der Umgebungsdruck des Reaktors.

Ein Reaktor kann zugleich temperierbar, druckfest und vakuumfest sein, alle Kombinationen sind möglich. Ein Reaktor kann aber auch jeweils nur eins der zuvor genannten Merkmale erfüllen.

Die Mindestanforderungen für die eingesetzten Reaktoren sind:

- Reaktor A: temperierbar und vakuumfest
- Reaktor B: temperierbar und druckfest
- Reaktor C: temperierbar

Technische optionale Besonderheiten für die einzelnen Reaktoren für spezielle Varianten der Erfindung:

Reaktor A:

- System zur Vorheizung, Trocknung und Inertisierung der porösen Partikel
- Es kann ein System zu gezielten Zugabe/Dosierung der porösen Partikel (technische Beschreibung siehe Phase 1.1) angeschlossen werden.
- Zum Trocknen bzw. Entfernen Verunreinigungen der porösen Partikel kann, ein System angeschlossen werden, dass es erlaubt kondensierbare oder resublimierbare Stoffe zu entfernen.
- Es kann ein System angeschlossen werden, mit dem die porösen Partikel in den Reaktor B überführt werden können (technische Beschreibung siehe Phase 1.3)

Reaktor B:

- System zur Luftkühlung
- Zur Erhöhung des Volumens, kann ein weiterer druckfester Behälter angeschlossen sein, der im einzelnen Reaktionszyklus höhere Reaktivkomponentenmengen erlaubt. Dieser Behälter kann beheizt sein oder nicht. Der Druckausgleich zwischen dem Behälter und Reaktor B kann passiv (Diffusion) oder aktiv (technisch gefördert) erfolgen.
- Zur Prozessvereinfachung kann ein Wasserstoffabscheider (technisch Beschreibung, siehe Phase 3.1) angeschlossen sein.
- Zur Entfernung von in den gasförmigen Reaktionsprodukten auftretenden, kondensierbaren oder resublimierbaren Nebenprodukten kann ein Behälter angeschlossen werden, der es
- erlaubt die Nebenprodukte durch Kondensation oder Resublimation zu entfernen.
- Es kann ein System angeschlossen werden, mit dem das Material in den Reaktor C oder einen Vorratsbehälter überführt werden kann (technische Beschreibung siehe Phase 1.3)

Reaktor C

- System zur Entfernung von kondensierbaren oder resublimierbaren Nebenprodukten. Es kann ein Behälter angeschlossen werden, der es erlaubt die Nebenprodukte durch Kondensation oder Resublimation zu entfernen.

Kaskadenreaktorsystem im Sinne der Anmeldung ist die Verknüpfung von mindestens 2 Reaktoren. Die Anzahl von Reaktoren ist nach oben offen. Die Anzahl der Reaktor A, B und C zueinander sowie deren Größen, Form, Material und Ausgestaltungen können unterschiedlich sein. Der Fachmann kann die Mengen an Reaktoren und deren Größen aufeinander abstimmen um insgesamt den Output des Kaskadenreaktorsystems so effizient wie möglich zu gestalten. Die Reaktoren können direkt miteinander verbunden sein oder örtlich voneinander getrennt sein, die Beschickung erfolgt dann mittels beweglichen Vorratsbehältern. Denkbar ist auch, dass mehrere Reaktoren B miteinander verschaltet werden und jeder Reaktionsschritt in einem extra Reaktor B abläuft.

Als Reaktoren im Sinne dieser Anmeldung werden bevorzugt Reaktortypen ausgewählt aus der Gruppe umfassend Rohrreaktoren, Retortenöfen, Wirbelschichtreaktoren, Festbettreaktoren und Autoklaven. Besonders bevorzugt kommen Wirbelschichtreaktoren und Autoklaven, insbesondere bevorzugt Autoklaven zum Einsatz.

Die porösen Partikel sowie das entstehende Silicium enthaltende Material können während des Prozesses allgemein als unbewegte Schüttung oder unter Durchmischung bewegt vorliegen. Eine bewegte Durchmischung der porösen Partikel beziehungsweise des entstehenden Silicium enthaltenden Materials in Reaktor A, B und C ist bevorzugt. Dadurch kann beispielsweise ein homogener Kontakt aller poröser Partikel mit Reaktivkomponenten oder eine homogene Temperaturverteilung der Schüttung erreicht werden. Die Bewegung der Partikel kann beispielsweise durch Rühreinbauten im Reaktor, die Bewegung des gesamten Reaktors, oder auch durch Fluidisierung der im Reaktor befindlichen Feststoffe mit einer Gasströmung erreicht werden.

Als Reaktortypen für eine unbewegte Schüttung ohne Durchmischung sind Ausführungsformen beliebiger Geometrie einsetzbar. Bevorzugt sind zylinderförmige, konusförmige, kugelförmige, polyedrische Reaktorbauformen oder Kombinationen davon.

Um eine Schüttung in Reaktor A, B und C zu durchmischen, sind alle Reaktorbauformen bevorzugt, in denen Feststoffschüttungen bewegt werden können. Das sind zum Beispiel sich bewegende Reaktoren, Reaktoren mit sich bewegenden Rührorganen oder Gas durchströmte Reaktoren oder Kombinationen davon.

Die Bewegungsform von sich bewegenden Reaktoren ist bevorzugt eine Rotationsbewegung. Andere Bewegungsformen sind ebenfalls geeignet. Bevorzugte Bauformen für rotierende Reaktoren sind beispielsweise Trommel- oder Rohrreaktoren, konusförmige Reaktoren, Doppelkonusreaktoren, Reaktoren mit versetzten Konen, kugelförmige Reaktoren, polyedrische Reaktoren, V-förmige Reaktoren, Doppel-V-förmige Reaktoren oder geometrische Kombinationen davon. Die Rotationsachse liegt bei symmetrischen Bauformen bevorzugt in der Symmetrieachse des Reaktors. Bei nichtsymmetrischen Bauformen geht die Rotationsachse bevorzugt durch den Reaktorschwerpunkt. Die Rotationsachse wird in einer weiteren bevorzugten Ausführungsform so gewählt, dass eine Taumelbewegung entsteht. Die Mischvorgänge innerhalb des sich bewegenden Reaktors werden vorzugsweise durch Einbauten verstärkt. Typische Einbauten sind Leitbleche, Blätter, Schaufeln und Pflugscharen. Die Ausrichtung der Rotationsachse ist dabei erfindungsgemäß frei wählbar. Rotationsachsen sind bevorzugt vertikal, horizontal oder in einem freien Winkel im Bezug zur horizontalen Ausführung ausgerichtet. Eine weitere bevorzugte Bauform zur Durchmischung von Schüttungen sind feststehende Reaktoren A, B und C mit sich bewegenden Rührorganen. Bevorzugte Geometrien hierfür sind zylindrische Reaktoren, konische Reaktoren, kugelförmige, polyedrische Reaktoren oder Kombinationen davon. Die Bewegung des Rührorgans ist bevorzugt eine Rotationsbewegung. Andere Bewegungsformen sind ebenfalls geeignet. Der Antrieb des Rührorgans erfolgt bevorzugt über eine Rührwelle, wobei pro Rührwelle ein Rührorgan oder mehrere Rührorgane vorhanden sein können. In den Reaktor A, B und C werden bevorzugt mehrere Rührwellen eingebracht, auf denen jeweils ein Rührorgan oder mehrere Rührorgane vorhanden sein können. Die Hauptreaktorachse ist vorzugsweise horizontal oder vertikal ausgerichtet. Die Rührwellen werden in einer weiteren bevorzugten Ausführungsform horizontal oder vertikal in einen beliebig orientierten Reaktor eingebaut. Für vertikal betriebene Reaktoren A, B und C sind Bauformen bevorzugt, bei denen beispielsweise über eine Hauptrührwelle ein Rührorgan oder mehrere Rührorgane durch eine Rotationsbewegung das Schüttgut durchmischen. Es sind weiterhin Bauformen bevorzugt, bei denen zwei oder mehr Rührwellen parallel laufen. Es sind zudem Bauformen bevorzugt, bei denen zwei oder mehr Rührwellen nicht parallel zueinander betrieben werden. Eine weitere bevorzugte Bauform für einen vertikal betriebenen Reaktor A, B oder C ist durch die Nutzung einer Förderschnecke gekennzeichnet. Die Förderschnecke fördert bevorzugt zentral das Schüttgut. Eine weitere erfindungsgemäße Bauart ist die am Rand des Reaktors entlang rotierende Förderschnecke. Für horizontal betriebene Reaktoren A, B oder C sind Bauformen bevorzugt, bei denen beispielsweise über eine Hauptrührwelle ein Rührorgan oder mehrere Rührorgane durch eine Rotationsbewegung das Schüttgut durchmischen. Es sind auch Bauformen möglich, bei denen zwei oder mehr Rührwellen parallel laufen. Es sind weiterhin Bauformen bevorzugt, bei denen zwei oder mehr Rührwellen nicht parallel zueinander betrieben werden. Für vertikal betriebene Reaktoren A, B oder C sind Rührorgane bevorzugt, ausgewählt aus der Gruppe enthaltend Wendelrührer, Spiralrührer, Ankerrührer oder allgemein Rührorgane, die das Schüttgut axial oder radial oder sowohl axial als auch radial fördern. Bei horizontal betriebenen Reaktoren A, B oder C sind bevorzugt mehrere Rührorgane auf einer Welle vorhanden. Erfindungsgemäße Bauformen für die Rührorgane von horizontal betriebenen Reaktoren sind Pflugschar, Paddel, Blattrührer, Spiralrührer oder allgemein Rührorgane, die das Schüttgut sowohl axial als auch radial fördern. Neben den sich bewegenden Rührorganen sind für den feststehenden Reaktor A, B oder C mit sich bewegenden Rührorganen auch starre Einbauten, wie Leitbleche bevorzugt. Insbesondere sind auch Bauformen bevorzugt, bei denen sowohl der Reaktor als auch ein Rührorgan rotieren.

Als weitere Möglichkeit zur Durchmischung werden Schüttgüter bevorzugt mit Gasströmen beaufschlagt. Hier sind Bauformen wie Wirbelschichtreaktoren besonders bevorzugt. Weiter bevorzugt sind Reaktoren A, B oder C, bei denen gezielt durch Einsatz von Pneumatik Mischzonen im Reaktor herbeigeführt werden.

Für den Bau von Reaktor A, B oder C für die Durchführung des erfindungsgemäßen Verfahrens ist grundsätzlich jeder Werkstoff geeignet, der bei den jeweiligen Prozessbedingungen die notwendige mechanische Festigkeit und chemische Beständigkeit aufweist. Bezüglich der chemischen Beständigkeit kann der Reaktor A, B oder C sowohl aus entsprechenden Vollmaterialien als auch aus chemisch nicht beständigen Materialien (drucktragend) mit speziellen Beschichtungen oder Plattierungen medienberührter Teile bestehen.

Dabei werden die Materialien erfindungsgemäß ausgewählt aus der Gruppe enthaltend:

- metallische Werkstoffe, die (gemäß DIN CEN ISO/TR 15608) für Stähle den Werkstoffgruppen 1 bis 11, für Nickel und Nickellegierungen den Gruppen 31 bis 38, für Titan und Titanlegierungen den Gruppen 51 bis 54, für Zirkonium und Zirkoniumlegierungen den Gruppen 61 und 62 und für Gusseisen den Gruppen 71 bis 76 entsprechen,
- keramische Werkstoffe aus Oxid-Keramiken im Einstoffsystem, wie beispielsweise Aluminiumoxid, Magnesiumoxid, Zirkoniumoxid, Titandioxid (Kondensatorwerkstoff) sowie Mehrstoffsysteme, wie beispielsweise Aluminiumtitanat (Mischform aus Aluminium- und Titanoxid), Mullit (Mischform aus Aluminium- und Siliciumoxid), Bleizirkonattitanat (Piezokeramik), oder Dispersionskeramiken wie mit Zirkoniumoxid verstärktes Aluminiumoxid (ZTA - Zirconia Toughened Aluminum Oxide) - $Al_2O_3/ZrO_2$),
- Nicht-Oxid-Keramiken, wie beispielsweise Carbide, zum Beispiel Siliciumcarbid und Borcarbid, Nitride, zum Beispiel Siliciumnitrid, Aluminiumnitrid, Bornitrid und Titannitrid, Boride und Silicide sowie deren Mischungen und
- Verbund- bzw. Kompositwerkstoffe, die zu den Gruppen der Teilchenverbundwerkstoffe, wie beispielsweise Hartmetall, Keramikverbunde, Beton und Polymerbeton, der Faserverbundwerkstoffe, wie beispielsweise glasfaserverstärktes Glas, Metallmatrix-Verbunde (MMC), Faserzement, kohlefaserverstärktes Siliciumcarbid, eigenverstärkte Thermoplaste, Stahlbeton, Faserbeton, Faser-Kunststoff-Verbunde, wie beispielsweise kohlenstofffaserverstärkter Kunststoff (CFK), glasfaserverstärkter Kunststoff (GfK) und aramidfaserverstärkter Kunststoff (AFK), Faser-Keramik-Verbunde (Ceramic Matrix Composites (CMC)), der Durchdringungsverbundwerkstoffe, wie beispielsweise Metall-Matrix-Verbunde (MMC), dispersionsverfestigte Aluminiumlegierungen oder dispersionsgehärtete Nickelchrom-Superlegierungen, der Schichtverbundwerkstoffe, wie beispielsweise Bimetalle, Titangraphit-Komposit, Verbundplatten und -rohre, glasfaserverstärktes Aluminium und Sandwich-Konstruktionen, und der Strukturverbundwerkstoffe zählen.

Das erfindungsgemäße Verfahren zur Herstellung von Siliciumhaltigen Materialien bietet verschiedene entscheidende Vorteile gegenüber dem Stand der Technik. Vorteilhaft ist insbesondere die Möglichkeit zur vollständigen Umsetzung des Silicium-Präkursors in kurzer Reaktionszeit beispielsweise unterstützt durch den während der Phase 4 auftretenden nicht allein temperaturbedingten Druckanstieg. Vorteilhaft ist zudem die Möglichkeit zur Reduktion der Menge an Inertgas beziehungsweise dessen vollständige Vermeidung, was ebenfalls zu höheren Raum-/Zeitausbeuten führt und somit eine schnellere und homogene Abscheidung der gewünschten Schichten auf den Substraten ermöglicht. Zudem kann die kontinuierliche Rückführung oder Aufarbeitung des Reaktorabgases, wie es üblicherweise im Betrieb eines offenen Reaktors anfällt, vermieden werden. Darüber hinaus ermöglicht die beschriebene Durchführung in einem verschließbaren Reaktor die einfache Durchführung von Mehrfachabscheidungen aus dem gleichen oder auch aus verschiedenen Reaktivkomponenten mit exakt einstellbarer Menge an Abscheidungsprodukt bezogen auf das Edukt des jeweiligen Abscheideschrittes. Die aus dem erfindungsgemäßen Verfahren erhaltenen Silicium enthaltenden Materialien zeichnen sich somit auch durch die vorteilhafte Homogenität der abgeschiedenen Schichten aus. Durch die Vorteile des erfindungsgemäßen Verfahrens werden Silicium enthaltende Materialien insbesondere für die Anwendung als Aktivmaterial für Anoden von Lithium-Ionen-Batterien mit hervorragenden Eigenschaften schnell und wirtschaftlich in vorteilhafter Weise zugänglich. Insbesondere vorteilhaft ist zudem, dass die oft beschriebene Staubbildung vermieden werden kann. Dies kann beispielsweise durch die große Oberfläche der porösen Partikel, die für die Abscheidung von Silicium aus dem Silicium-Präkursor zur Verfügung gestellt wird, sowie die intensive Durchdringung der porösen Partikel mit den Silicium-Präkursoren erreicht werden. Gleichzeitig ergibt sich so eine hohe Ausbeute an abgeschiedenem Silicium. Im Gegensatz zu einer Variante, in der alle Reaktionsschritten im selben Reaktor durchgeführt werden (siehe Gegenbeispiel 2), bietet der Kaskadenreaktor folgende Vorteile:

- Energieeinsparungen durch Verminderung von Abkühl- und Aufheizprozessen mit hohem Temperaturunterschied.
- Einsparung von Investitionskosten durch präzise Auslegung der jeweiligen Reaktoren auf die Anforderungen des jeweiligen Prozessschrittes.
- Hohes Maß an Modularität bietet breite Möglichkeiten der Anpassung an variierende Mengenanforderungen und Prozessparameter.
- Möglichkeit der Kombination der verschiedenen Reaktoren A, B und C in unterschiedlichen Dimensionen und Stückzahlen verringert das Komplettausfallrisiko und schafft Planbarkeit von notwendigen Revisionsstandzeiten.
- Modularer Aufbau ermöglicht die Durchführung geringfügiger Wartungsarbeiten an einem Reaktor, während die anderen Reaktoren weiterhin in Betrieb sind.

Die porösen Partikel für das erfindungsgemäße Verfahren werden vorzugsweise ausgewählt aus der Gruppe enthaltend amorphen Kohlenstoff in Form von Hardcarbon, Softcarbon, Mesocarbon Microbeads, Naturgraphit oder synthetischem Graphit, ein- und mehrwandige Kohlenstoffnanoröhren und Graphen, Oxide wie Siliciumdioxid, Aluminiumoxid, Silicium-Aluminium-Mischoxide, Magnesiumoxid, Bleioxide und Zirkonoxid, Carbide wie Siliciumcarbide und Borcarbide, Nitride wie Siliciumnitride und Bornitride; und andere keramische Werkstoffe, wie sie sich durch folgende Komponentenformel beschreiben lassen:

$Al_aB_bC_cMg_dN_eO_fSi_g$ mit $0 \leq$ a, b, c, d, e, f, g $\leq 1$, mit mindestens zwei Koeffizienten a bis g $> 0$ und $a*3 + b*3 + c*4 + d*2 + g*4 \geq e*3 + f*2$.

Die keramischen Werkstoffe können beispielsweise binäre, ternäre, quaternäre, quinäre, senäre oder septernäre Verbindungen sein. Bevorzugt sind keramische Werkstoffe mit folgenden Komponentenformeln:

Nichtstöchiometrische Bornitride $BN_z$ mit z = 0,2 bis 1,

Nichtstöchiometrische Kohlenstoffnitride $CN_z$ mit z = 0,1 bis 4/3,

Borcarbonitride $B_xCN_z$ mit x = 0,1 bis 20 und z = 0,1 bis 20, wobei gilt $x*3 + 4 \geq z*3$,

Bornitridooxide $BN_zO_r$ mit z = 0,1 bis 1 und r = 0,1 bis 1, wobei gilt $3 \geq r*2 + z*3$,

Borcarbonitridooxide $B_xCN_zO_r$ mit x = 0,1 bis 2, z = 0,1 bis 1 und r = 0,1 bis 1, wobei gilt: $x*3 + 4 \geq r*2 + z*3$,

Siliciumcarbooxide $Si_xCO_z$ mit x = 0,1 bis 2 und z = 0,1 bis 2, wobei gilt $x*4 + 4 \geq z*2$,

Siliciumcarbonitride $Si_xCN_z$ mit x = 0,1 bis 3 und z = 0,1 bis 4, wobei gilt $x*4 + 4 \geq z*3$,

Siliciumborocarbonitride $Si_wB_xCN_z$ mit w = 0,1 bis 3, x = 0,1 bis 2 und z = 0,1 bis 4, wobei gilt $w*4 + x*3 + 4 \geq z*3$,

Siliciumborocarbooxide $Si_wB_xCO_z$ mit w = 0,10 bis 3, x = 0,1 bis 2 und z = 0,1 bis 4, wobei gilt $w*4 + x*3 + 4 \geq z*2$,

Siliciumborocarbonitridooxide $Si_vB_wCN_xO_z$ mit v = 0,1 bis 3, w = 0,1 bis 2, x = 0,1 bis 4 und z = 0,1 bis 3, wobei gilt $v*4 + w*3 + 4 \geq x*3 + z*2$ und

Aluminiumborosilicocarbonitridooxide $Al_uB_ySi_xCN_wO_z$ mit u = 0,1 bis 2, v = 0,1 bis 2, w = 0,1 bis 4, x = 0,1 bis 2 und z = 0,1 bis 3, wobei gilt $u*3 + v*3 + x*4 + 4 \geq w*3 + z*2$.

Bevorzugt besitzen die porösen Partikel eine durch Heliumpyknometrie bestimmte Dichte von 0,1 bis 7 $g/cm^3$ und besonders bevorzugt von 0,3 bis 3 $g/cm^3$. Dies ist vorteilhaft zur Steigerung der gravimetrischen Kapazität ($mAh/cm^3$) von Lithium-Ionen-Batterien.

Bevorzugt kommen als poröse Partikel amorphe Kohlenstoffe, Siliciumdioxid, Bornitrid, Siliciumcarbid sowie Siliciumnitrid oder auch Mischwerkstoffe auf Basis dieser Materialien zum Einsatz, besonders bevorzugt ist die Verwendung von amorphen Kohlenstoffen, Bornitrid und Siliciumdioxid.

Die porösen Partikel weisen eine volumengewichtete Partikelgrößenverteilung mit Durchmesser-Perzentilen $d_{50}$ auf von vorzugsweise $\geq 0,5$ $\mu$m, besonders bevorzugt $\geq 1,5$ $\mu$m und am meisten bevorzugt $\geq 2$ $\mu$m. Die Durchmesser-Perzentile $d_{50}$ sind vorzugsweise $\leq 20$ $\mu$m, besonders bevorzugt $\leq 12$ $\mu$m und am meisten bevorzugt $\leq 8$ $\mu$m.

Die volumengewichtete Partikelgrößenverteilung der porösen Partikel liegt vorzugsweise zwischen den Durchmesser-Perzentilen $d_{10} \geq 0,2$ $\mu$m und $d_{90} \leq 20,0$ $\mu$m, besonders bevorzugt zwischen $d_{10} \geq 0,4$ $\mu$m und $d_{90} \leq 15,0$ $\mu$m und am meisten bevorzugt zwischen $d_{10} \geq 0,6$ $\mu$m bis $d_{90} \leq 12,0$ $\mu$m.

Die porösen Partikel haben eine volumengewichtete Partikelgrößenverteilung mit Durchmesser-Perzentilen $d_{10}$ von vorzugsweise $\leq 10$ $\mu$m, besonders bevorzugt $\leq 5$ $\mu$m, insbesondere bevorzugt $\leq 3$ $\mu$m und am meisten bevorzugt $\leq 2$ $\mu$m. Die Durchmesser-Perzentile $d_{10}$ sind vorzugsweise $\geq 0,2$ $\mu$m, besonders bevorzugt $\geq 0,5$ und am meisten bevorzugt $\geq 1$ $\mu$m.

Die porösen Partikel haben eine volumengewichtete Partikelgrößenverteilung mit Durchmesser-Perzentilen $d_{90}$ von vorzugsweise $\geq 4$ $\mu$m und besonders bevorzugt $\geq 8$ $\mu$m. Die Durchmesser-Perzentile $d_{90}$ sind vorzugsweise $\leq 18$ $\mu$m, besonders bevorzugt $\leq 15$ und am meisten bevorzugt $\leq 13$ $\mu$m.

Die volumengewichtete Partikelgrößenverteilung der porösen Partikel hat eine Breite $d_{90}$-$d_{10}$ von vorzugsweise $\leq 15,0$ $\mu$m, mehr bevorzugt $\leq 12,0$ $\mu$m, besonders bevorzugt $\leq 10,0$ $\mu$m, insbesondere bevorzugt $\leq 8,0$ $\mu$m und am meisten

bevorzugt $\leq 4{,}0\ \mu m$.

Die volumengewichtete Partikelgrößenverteilung der nach dem erfindungsgemäßen Verfahren herstellbaren Silicium enthaltenden Materialien hat eine Breite $d_{90}$-$d_{10}$ von vorzugsweise $\geq 0{,}6\ \mu m$, besonders bevorzugt $\geq 0{,}8\ \mu m$ und am meisten bevorzugt $\geq 1{,}0\ \mu m$.

Die volumengewichtete Partikelgrößenverteilung der porösen Partikel ist bestimmbar nach ISO 13320 mittels statischer Laserstreuung unter Anwendung des Mie-Modells mit dem Messgerät Horiba LA 950 mit Ethanol als Dispergiermedium für die porösen Partikel.

Die porösen Partikel liegen vorzugsweise in Form von Partikeln vor. Die Partikel können beispielsweise isoliert oder agglomeriert vorliegen. Die porösen Partikel sind vorzugsweise nicht aggregiert und vorzugsweise nicht agglomeriert. Aggregiert bedeutet allgemein, dass im Zuge der Herstellung der porösen Partikel zunächst Primärpartikel gebildet werden und zusammenwachsen und/oder Primärpartikel beispielsweise über kovalente Bindungen miteinander verknüpft sind und auf diese Weise Aggregate bilden. Primärpartikel sind allgemein isolierte Partikel. Aggregate oder isolierte Partikel können Agglomerate bilden. Agglomerate sind eine lose Zusammenballung von Aggregaten oder Primärpartikeln, die beispielsweise über Van-der-Waals-Wechselwirkungen oder Wasserstoffbrückenbindungen miteinander verknüpft sind. Agglomerierte Aggregate können nach gängigen Knet- und Dispergierverfahren leicht wieder in Aggregate aufgespalten werden. Aggregate lassen sich mit diesen Verfahren nicht oder nur teilweise in die Primärpartikel zerlegen. Das Vorliegen der porösen Partikel in Form von Aggregaten, Agglomeraten oder isolierten Partikeln kann beispielsweise mittels herkömmlicher Raster-Elektronen-Mikroskopie (REM) sichtbar gemacht werden. Statische Lichtstreuungsmethoden zur Bestimmung der Teilchengrößenverteilungen oder Partikeldurchmessern von Matrixpartikeln können dagegen nicht zwischen Aggregaten oder Agglomeraten unterscheiden.

Die porösen Partikel können eine beliebige Morphologie aufweisen, also beispielsweise splittrig, plattig, sphärisch oder auch nadelförmig sein, wobei splittrige oder sphärische Partikel bevorzugt sind. Die Morphologie kann beispielsweise durch die Sphärizität $\psi$ oder die Sphärizität S charakterisiert werden. Gemäß der Definition von Wadell ist die Sphärizität $\psi$ das Verhältnis aus der Oberfläche einer Kugel gleichen Volumens zur tatsächlichen Oberfläche eines Körpers. Im Falle einer Kugel hat $\psi$ den Wert 1. Nach dieser Definition haben die porösen Partikel für das erfindungsgemäße Verfahren eine Sphärizität $\psi$ von vorzugsweise 0,3 bis 1,0 besonders bevorzugt von 0,5 bis 1,0 und am meisten bevorzugt von 0,65 bis 1,0.

Die Sphärizität S ist das Verhältnis aus dem Umfang eines äquivalenten Kreises mit gleicher Fläche A wie die Projektion des auf eine Fläche projizierten Partikels und dem gemessenen Umfang U dieser Projektion:
$S = 2\sqrt{\pi A}/U$. Im Falle eines ideal kreisförmigen Partikels hätte S den Wert 1. Für die porösen Partikel für das erfindungsgemäße Verfahren liegt die Sphärizität $S$ im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität S erfolgt beispielsweise anhand von Aufnahmen einzelner Partikel mit einem optischen Mikroskop oder bei Partikeln < 10 $\mu m$ bevorzugt mit einem Rasterelektronenmikroskop durch grafische Auswertung mittels einer Bildanalysesoftware, wie beispielsweise ImageJ.

Die porösen Partikel weisen bevorzugt ein gaszugängliches Porenvolumen von $\geq 0{,}2\ cm^3/g$, besonders bevorzugt $\geq 0{,}6\ cm^3/g$ und am meisten bevorzugt $\geq 1{,}0\ cm^3/g$ auf. Dies ist förderlich, um Lithium-Ionen-Batterien mit hoher Kapazität zu erhalten. Das gaszugängliche Porenvolumen wurde durch Gassorptionsmessungen mit Stickstoff gemäß DIN 66134 bestimmt.

Die porösen Partikel sind vorzugsweise offenporig. Offenporig bedeutet allgemein, dass Poren mit der Oberfläche von Partikeln verbunden sind, beispielsweise über Kanäle, und vorzugsweise mit der Umgebung in stofflichem Austausch, insbesondere in Austausch von gasförmigen Verbindungen, stehen können. Dies lässt sich anhand von Gassorptionsmessungen (Auswertung nach Brunauer, Emmett und Teller, BET"), also der spezifischen Oberfläche nachweisen. Die porösen Partikel weisen spezifische Oberflächen von bevorzugt $\geq 50\ m^2/g$, besonders bevorzugt $\geq 500$ $m^2/g$ und am meisten bevorzugt $\geq 1000\ m^2/g$ auf. Die BET-Oberfläche wird gemäß DIN 66131 (mit Stickstoff) bestimmt.

Die Poren der porösen Partikel können beliebige Durchmesser aufweisen, also allgemein im Bereich von Makroporen (oberhalb von 50 nm), Mesoporen (2 - 50 nm) und Mikroporen (kleiner 2 nm) liegen. Die porösen Partikel können in beliebigen Mischungen verschiedener Porentypen eingesetzt werden. Bevorzugt werden poröse Partikel mit weniger als 30% Makroporen, bezogen auf das Gesamtporenvolumen, besonders bevorzugt poröse Partikel ohne Makroporen und ganz besonders bevorzugt poröse Partikel mit zumindest 50% Poren mit einem mittleren Porendurchmesser unter 5 nm eingesetzt. Ganz besonders bevorzugt weisen die porösen Partikel ausschließlich Poren mit einem Porendurchmesser kleiner 2 nm auf (Bestimmungsmethode: Porengrößenverteilung nach BJH (Gasadsorption) gemäß DIN 66134 im Mesoporenbereich und nach Horvath-Kawazoe (Gasadsorption) gemäß DIN 66135 im Mikroporenbereich; die Bewertung der Porengrößenverteilung im Makroporen-Bereich erfolgt durch Quecksilberporosimetrie nach DIN ISO 15901-1).

Bevorzugt sind poröse Partikel mit gasunzugänglichem Porenvolumen von kleiner 0,3 $cm^3/g$ und besonders bevorzugt kleiner 0,15 $cm^3/g$. Auch damit kann die Kapazität der Lithium-Ionen-Batterien gesteigert werden. Das gasunzugängliche Porenvolumen kann mittels der folgenden Formel bestimmt werden:

Gasunzugängliches Porenvolumen = 1/Reinmaterialdichte - 1/Ske- lettdichte.

Dabei ist die Reinmaterialdichte eine theoretische Dichte der porösen Partikel, basierend auf der Phasenzusammensetzung oder der Dichte des Reinstoffes (Dichte des Materials als hätte es keine geschlossene Porosität). Daten zu Reinmaterialdichten lassen sich durch den Fachmann beispielsweise dem Ceramic Data Portal des National Institute of Standards entnehmen (NIST, https://srdata.nist.gov/CeramicDataPortal/scd). Beispielsweise beträgt die Reinmaterialdichte von Siliciumoxid 2,203 g/cm$^3$, die von Bornitrid beträgt 2,25 g cm$^3$, die von Siliciumnitrid beträgt 3,44 g/cm$^3$ und die von Siliciumcarbid beträgt 3,21 g/cm$^3$. Die Skelettdichte ist die tatsächliche, durch Heliumpyknometrie bestimmte Dichte der porösen Partikel (Gas-zugänglich).

Klarstellend sei angemerkt, dass die porösen Partikel vom Silicium enthaltenden Material verschieden sind. Die porösen Partikel fungieren als Startmaterial zur Herstellung des Silicium enthaltenden Materials. Vorzugsweise befindet sich in den Poren der porösen Partikel und auf der Oberfläche der porösen Partikel allgemein kein Silicium, insbesondere kein Silicium, das durch Abscheiden von Silicium-Präkursoren erhalten wird.

Das mittels Abscheidung von Silicium in Poren und auf der Oberfläche der porösen Partikel nach dem erfindungsgemäßen Verfahren erhältliche Silicium enthaltende Material weist eine volumengewichtete Partikelgrößenverteilung mit Durchmesser-Perzentilen $d_{50}$ vorzugsweise in einem Bereich von 0,5 bis 20 $\mu$m auf. Bevorzugt beträgt der $d_{50}$-Wert zumindest 1,5 $\mu$m, und besonders bevorzugt zumindest 2 $\mu$m. Die Durchmesser-Perzentile $d_{50}$ betragen vorzugsweise höchstens 13 $\mu$m und besonders bevorzugt höchstens 8 $\mu$m.

Die volumengewichtete Partikelgrößenverteilung des Silicium enthaltenden Materials liegt vorzugsweise zwischen den Durchmesser-Perzentilen $d_{10} \geq 0,2$ $\mu$m und $d_{90} \leq 20,0$ $\mu$m, besonders bevorzugt zwischen $d_{10} \geq 0,4$ $\mu$m und $d_{90} \leq 15,0$ $\mu$m und am meisten bevorzugt zwischen $d_{10} \geq 0,6$ $\mu$m bis $d_{90} \leq 12,0$ $\mu$m.

Das Silicium enthaltende Material hat eine volumengewichtete Partikelgrößenverteilung mit Durchmesser-Perzentilen $d_{10}$ von vorzugsweise $\leq 10$ $\mu$m, besonders bevorzugt $\leq 5$ $\mu$m, insbesondere bevorzugt $\leq 3$ $\mu$m und am meisten bevorzugt $\leq 1$ $\mu$m. Die Durchmesser-Perzentile $d_{10}$ sind vorzugsweise $\geq 0,2$ $\mu$m, besonders bevorzugt $\geq 0,4$ $\mu$m und am meisten bevorzugt $\geq 0,6$ $\mu$m.

Das Silicium enthaltende Material hat eine volumengewichtete Partikelgrößenverteilung mit Durchmesser-Perzentilen $d_{90}$ von vorzugsweise $\geq 5$ $\mu$m und besonders bevorzugt $\geq 10$ $\mu$m. Die Durchmesser-Perzentile $d_{90}$ sind vorzugsweise $\leq 20$ $\mu$m, besonders bevorzugt $\leq 15$ $\mu$m und am meisten bevorzugt $\leq 12$ $\mu$m.

Die volumengewichtete Partikelgrößenverteilung des Silicium enthaltenden Materials hat eine Breite $d_{90}$-$d_{10}$ von vorzugsweise $\leq 15,0$ $\mu$m, besonders bevorzugt $\leq 12,0$ $\mu$m, mehr bevorzugt $\leq 10,0$ $\mu$m, insbesondere bevorzugt $\leq 8,0$ $\mu$m und am meisten bevorzugt $\leq 4,0$ $\mu$m. Die volumengewichtete Partikelgrößenverteilung des Silicium enthaltenden Materials hat eine Breite $d_{90}$-$d_{10}$ von vorzugsweise $\geq 0,6$ $\mu$m, besonders bevorzugt $\geq 0,8$ $\mu$m und am meisten bevorzugt $\geq 1,0$ $\mu$m.

Die Partikel des Silicium enthaltenden Materials liegt vorzugsweise in Form von Partikeln vor. Die Partikel können isoliert oder agglomeriert vorliegen. Das Silicium enthaltende Material ist vorzugsweise nicht aggregiert und vorzugsweise nicht agglomeriert. Die Begriffe isoliert, agglomeriert und nicht aggregiert sind weiter oben in Bezug auf die porösen Partikel schon definiert. Das Vorliegen von Silicium enthaltenden Materialien in Form von Aggregaten oder Agglomeraten kann beispielsweise mittels herkömmlicher Raster-Elektronen-Mikroskopie (REM) sichtbar gemacht werden.

Das Silicium enthaltende Material kann eine beliebige Morphologie aufweisen, also beispielsweise splittrig, plattig, sphärisch oder auch nadelförmig sein, wobei splittrige oder sphärische Partikel bevorzugt sind.

Gemäß der Definition von Wadell ist die Sphärizität $\psi$ das Verhältnis aus der Oberfläche einer Kugel gleichen Volumens zur tatsächlichen Oberfläche eines Körpers. Im Falle einer Kugel hat $\psi$ den Wert 1. Nach dieser Definition haben die nach dem erfindungsgemäßen Verfahren zugänglichen Silicium enthaltenden Materialien eine Sphärizität $\psi$ von vorzugsweise 0,3 bis 1,0 besonders bevorzugt von 0,5 bis 1,0 und am meisten bevorzugt von 0,65 bis 1,0.

Die Sphärizität $S$ ist das Verhältnis aus dem Umfang eines äquivalenten Kreises mit gleicher Fläche A wie die Projektion des auf eine Fläche projizierten Partikels und dem gemessenen Umfang U dieser Projektion:

$$S = 2\sqrt{\pi A}/U$$

. Im Falle eines ideal kreisförmigen Partikels hätte S den Wert 1. Für die nach dem erfindungsgemäßen Verfahren zugänglichen Silicium enthaltenden Materialien liegt die Sphärizität $S$ im Bereich von vorzugsweise 0,5 bis 1,0 und besonders bevorzugt von 0,65 bis 1,0, bezogen auf die Perzentile $S_{10}$ bis $S_{90}$ der Sphärizitäts-Anzahlverteilung. Die Messung der Sphärizität $S$ erfolgt beispielsweise anhand von Aufnahmen einzelner Partikel mit einem optischen Mikroskop oder bei Partikeln kleiner 10 $\mu$m bevorzugt mit einem Rasterelektronenmikroskop durch grafische Auswertung mittels einer Bildanalysesoftware, wie beispielsweise ImageJ.

Über die Morphologie, die materielle Zusammensetzung, insbesondere der spezifischen Oberfläche oder der inneren Porosität des Silicium enthaltenden Materials kann die Zyklisierungsstabilität von Lithium-Ionen-Batterien weiter gesteigert werden.

Das Silicium enthaltende Material enthält bevorzugt 10 bis 90 Gew.-%, mehr bevorzugt 20 bis 80 Gew.-%, besonders bevorzugt 30 bis 60 Gew.-% und insbesondere bevorzugt 40 bis 50 Gew.-% an porösen Partikeln, bezogen auf das Gesamtgewicht des Silicium enthaltenden Materials.

Das Silicium enthaltende Material enthält bevorzugt 10 bis 90 Gew.-%, mehr bevorzugt 20 bis 80 Gew.-%, besonders bevorzugt 30 bis 60 Gew.-% und insbesondere bevorzugt 40 bis 50 Gew.-% über die Abscheidung aus dem Silicium-Präkursor erhaltenes Silicium, bezogen auf das Gesamtgewicht des Silicium enthaltenden Materials (Bestimmung vorzugsweise mittels Elementaranalyse, wie ICP-OES).

Falls die porösen Partikel Siliciumverbindungen enthalten, beispielsweise in Form von Siliciumdioxid, lassen sich die vorgenannten Gew.-% Angaben für das über die Abscheidung aus dem Silicium-Präkursor erhaltene Silicium bestimmen, indem die mittels Elementaranalyse ermittelte Siliciummasse der porösen Partikel von der mittels Elementaranalyse ermittelte Siliciummasse des Silicium enthaltenden Materials subtrahiert wird und das Ergebnis durch die Masse des Silicium enthaltenden Materials dividiert wird.

Das Volumen des im Silicium enthaltenden Material enthaltenen, über die Abscheidung aus dem Silicium-Präkursor erhaltenen Siliciums, ergibt sich aus dem Massenanteil des über die Abscheidung aus dem Silicium-Präkursor erhaltenen Siliciums an der Gesamtmasse des Silicium enthaltenden Materials dividiert durch die Dichte von Silicium ($2,336$ g/cm$^3$).

Das Porenvolumen P der Silicium enthaltenden Materialien ergibt sich aus der Summe von gaszugänglichem und gasunzugänglichem Porenvolumen. Das gaszugängliche Porenvolumen nach Gurwitsch des Silicium enthaltenden Materials ist bestimmbar durch Gassorptionsmessungen mit Stickstoff nach DIN 66134.

Das gasunzugängliche Porenvolumen des Silicium enthaltenden Materials ist bestimmbar mit der Formel:

Gasunzugängliches Porenvolumen =1/Skelettdichte -1/Reinmateri- aldichte.

Dabei ist die Reinmaterialdichte eines Silicium enthaltenden Materials eine theoretische Dichte, die sich aus der Summe der theoretischen Reinmaterialdichten der im Silicium enthaltenden Material enthaltenen Komponenten, multipliziert mit ihrem jeweiligen Gewichts-bezogenen prozentualen Anteil am Gesamtmaterial, berechnen lässt. Beispielsweise ergibt sich damit für ein Silicium enthaltendes Material, bei dem Silicium auf einem porösen Partikel abgeschieden wird:

Reinmaterialdichte = theoretische Reinmaterialdichte des Sili- ciums * Anteil des Siliciums in Gew.-% + theoretische Reinmate- rialdichte der porösen Partikel * Anteil der porösen Partikel in Gew.-%.

Daten zu Reinmaterialdichten lassen sich durch den Fachmann beispielsweise dem Ceramic Data Portal des National Institute of Standards entnehmen (NIST, https://srdata.nist.gov/CeramicDataPortal/scd). Beispielsweise beträgt die Reinmaterialdichte von Siliciumoxid $2,203$ g/cm$^3$, die von Bornitrid beträgt $2,25$ g cm$^3$, die von Siliciumnitrid beträgt $3,44$ g/cm$^3$ und die von Siliciumcarbid beträgt $3,21$ g/cm$^3$.

Das Porenvolumen P der Silicium enthaltenden Materialien liegt bevorzugt im Bereich von 0 bis 400 Vol.-%, besonders bevorzugt im Bereich von 100 bis 350 Vol.-% und insbesondere bevorzugt im Bereich von 200 bis 350 Vol.-%, bezogen auf das Volumen des im Silicium enthaltenden Material enthaltenen, aus der Abscheidung aus dem Silicium-Präkursor erhaltenen Siliciums.

Die im Silicium enthaltenden Material enthaltene Porosität kann sowohl gaszugänglich als auch gasunzugänglich sein. Das Verhältnis des Volumens von gaszugänglicher zu gasunzugänglicher Porosität des Silicium enthaltenden Materials kann generell im Bereich von 0 (keine gaszugänglichen Poren) bis 1 (alle Poren sind gaszugänglich) liegen. Bevorzugt liegt das Verhältnis des Volumens von gaszugänglicher zu gasunzugänglicher Porosität des Silicium enthaltenden Materials im Bereich von 0 bis 0,8, besonders bevorzugt im Bereich von 0 bis 0,3 und insbesondere bevorzugt von 0 bis 0,1.

Die Poren des Silicium enthaltenden Materials können beliebige Durchmesser aufweisen, beispielsweise im Bereich von Makroporen (> 50 nm), Mesoporen (2-50 nm) und Mikroporen (< 2 nm) liegen. Das Silicium enthaltende Material kann auch beliebige Mischungen verschiedener Porentypen enthalten. Bevorzugt enthält das Silicium enthaltende Material höchstens 30% Makroporen, bezogen auf das Gesamtporenvolumen, besonders bevorzugt ist ein Silicium enthaltendes Material ohne Makroporen und ganz besonders bevorzugt ist ein Silicium enthaltendes Material mit mindestens 50% Poren bezogen auf das Gesamtporenvolumen mit einem mittleren Porendurchmesser unter 5 nm. Insbesondere bevorzugt weist das Silicium enthaltende Material ausschließlich Poren mit einem Durchmesser von höchstens 2 nm auf.

Das Silicium enthaltende Material weist Siliciumstrukturen auf, die in mindestens einer Dimension Strukturgrößen von bevorzugt höchstens 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)) aufweisen.

Bevorzugt enthält das Silicium enthaltende Material Silicium-schichten mit einer Schichtdicke unterhalb von 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)). Das Silicium enthaltende Material kann auch Silicium in Form von Partikeln enthalten. Siliciumpartikel haben einen Durchmesser von bevorzugt höchstens 1000 nm, mehr bevorzugt kleiner 100 nm, besonders bevorzugt kleiner 5 nm (Bestimmungsmethode: Raster-Elektronen-Mikroskopie (REM) und/oder High-Resolution-Transmissions-Electron-Microscopy (HR-TEM)). Die Angabe zu den Siliciumpartikeln bezieht sich hierbei vorzugsweise auf den Durchmesser des Umkreises der Partikel im Mikroskopbild.

Das Silicium enthaltende Material hat bevorzugt eine spezifische Oberfläche von höchstens 100 $m^2/g$, besonders bevorzugt kleiner 30 $m^2/g$, und insbesondere bevorzugt kleiner 10 $m^2/g$. Die BET-Oberfläche wird gemäß DIN 66131 (mit Stickstoff) bestimmt. Damit kann bei Einsatz des Silicium enthaltenden Materials als Aktivmaterial in Anoden für Lithium-Ionen-Batterien die SEI-Bildung reduziert und die initiale Couloumb-Effizienz gesteigert werden.

Ferner kann das aus dem Silicium-Präkursor abgeschiedene Silicium im Silicium enthaltenden Material Dotierstoffe enthalten, beispielsweise ausgewählt aus der Gruppe enthaltend Li, Fe, Al, Cu, Ca, K, Na, S, Cl, Zr, Ti, Pt, Ni, Cr, Sn, Mg, Ag, Co, Zn, B, P, Sb, Pb, Ge, Bi, seltene Erden oder Kombinationen daraus. Bevorzugt sind dabei Lithium und/oder Zinn. Der Gehalt an Dotierstoffen im Silicium enthaltenden Material ist bevorzugt höchstens 1 Gew.-% und besonders bevorzugt höchstens 100 ppm bezogen auf das Gesamtgewicht des Silicium enthaltenden Materials, bestimmbar mittels ICP-OES.

Das Silicium enthaltende Material weist allgemein eine überraschend hohe Stabilität bei Druckbelastung und/oder Scherbelastung auf. Die Druckstabilität und die Scherstabilität des Silicium enthaltenden Materials zeigt sich dabei beispielsweise dadurch, dass das Silicium enthaltende Material bei Druck-(beispielsweise bei der Elektrodenverdichtung) beziehungsweise Scher-Belastung (beispielsweise bei der Elektrodenpräparation) keine oder nur geringfügige Änderungen ihrer porösen Struktur im REM aufweist.

Das Silicium enthaltende Material kann gegebenenfalls zusätzlich Elemente, wie Kohlenstoff, enthalten. Bevorzugt ist Kohlenstoff in Form von dünnen Schichten mit einer Schichtdicke von höchstens 1 $\mu$m, bevorzugt kleiner 100 nm, besonders bevorzugt kleiner 5 nm und ganz besonders bevorzugt kleiner 1 nm enthalten (bestimmbar über REM bzw. HR-TEM). Die Kohlenstoffschichten können dabei sowohl in den Poren als auch auf der Oberfläche des Silicium enthaltenden Materials vorhanden sein. Auch die Reihenfolge verschiedener Schichten im Silicium enthaltenden Material durch entsprechende Wiederholungen der Phasen 2.1 bis 6.1 sowie deren Anzahl ist beliebig. So kann auf den porösen Partikeln zunächst eine Schicht eines weiteren, von den porösen Partikeln unterschiedlichen Materials, wie beispielsweise Kohlenstoff, vorhanden sein und darauf eine Siliciumschicht oder eine Schicht von Siliciumpartikeln zugegen sein. Auch kann auf der Siliciumschicht oder auf der Schicht von Siliciumpartikeln wiederum eine Schicht eines weiteren Materials vorhanden sein, welches vom Material der porösen Partikel verschieden oder gleich diesem sein kann, unabhängig davon, ob zwischen den porösen Partikeln und der Siliciumschicht oder der aus Siliciumpartikeln bestehenden Schicht eine weitere Schicht eines von dem Material der porösen Partikel unterschiedlichen Materials vorhanden ist.

Das Silicium enthaltende Material enthält vorzugsweise ≤ 50 Gew.-%, besonders bevorzugt ≤ 40 Gew.-% und insbesondere bevorzugt ≤ 20 Gew.-% an zusätzlichen Elementen. Das Silicium enthaltende Material enthält vorzugsweise ≥ 1 Gew.-%, besonders bevorzugt ≥ 3 Gew.-% und insbesondere bevorzugt ≥ 2 Gew.-% an zusätzlichen Elementen. Die Angaben in Gew.-% beziehen sich auf das Gesamtgewicht des Silicium enthaltenden Materials. In einer alternativen Ausführungsform enthält das Silicium enthaltende Material keine zusätzlichen Elemente.

Weiterhin beschrieben ist die Verwendung des Silicium enthaltenden Materials als Aktivmaterial in Anodenmaterialien für Anoden von Lithium-Ionen-Batterien sowie die Verwendung solcher Anoden zur Herstellung von Lithium-Ionen-Batterien.

Es ist beschrieben, dass das Anodenmaterial vorzugsweise auf einer Mischung basiert, umfassend das nach dem erfindungsgemäßen Verfahren zugängliche Silicium enthaltende Material, ein oder mehrere Bindemittel, gegebenenfalls Graphit als weiteres Aktivmaterial, gegebenenfalls ein oder mehrere weitere elektrisch leitende Komponenten und gegebenenfalls ein oder mehrere Additive.

Es ist beschrieben, dass durch Einsatz von weiteren elektrisch leitenden Komponenten im Anodenmaterial die Übergangswiderstände innerhalb der Elektrode sowie zwischen Elektrode und Stromableiter reduziert werden können, was die Strombelastbarkeit der erfindungsgemäßen Lithium-Ionen-Batterie verbessert. Bevorzugte weitere elektrisch leitende Komponenten sind beispielsweise Leitruß, Kohlenstoff-Nanoröhrchen oder metallische Partikel, wie beispielsweise Kupfer.

Es ist beschrieben, dass die Primärpartikel von Leitruß vorzugsweise eine volumengewichtete Partikelgrößenverteilung zwischen den Durchmesser-Perzentilen $d_{10}$ = 5 nm und $d_{90}$ = 200 nm haben. Die Primärpartikel von Leitruß können auch kettenartig verzweigt sein und bis zu $\mu$m-große Strukturen bilden. Kohlenstoff-Nanoröhrchen haben vorzugsweise Durchmesser von 0,4 bis 200 nm, besonders bevorzugt 2 bis 100 nm und am meisten bevorzugt 5 bis 30 nm. Die metallischen Partikel haben eine volumengewichtete Partikelgrößenverteilung, die bevorzugt zwischen den Durchmesser-Perzentilen $d_{10}$ = 5 nm und $d_{90}$ = 800 nm liegt.

Es ist beschrieben, dass das Anodenmaterial vorzugsweise 0 bis 95 Gew.-%, besonders bevorzugt 0 bis 40 Gew.-% und am meisten bevorzugt 0 bis 25 Gew.-% an einer oder mehreren weiteren elektrisch leitenden Komponenten, bezogen auf das Gesamtgewicht des Anodenmaterials, enthält.

Es ist beschrieben, dass das Silicium enthaltende Material in den Anoden für Lithium-Ionen-Batterien zu vorzugsweise 5 bis 100 Gew.-%, besonders bevorzugt 30 bis 100 Gew.-% und am meisten bevorzugt 60 bis 100 Gew.-%, bezogen auf das gesamte im Anodenmaterial enthaltene Aktivmaterial, enthalten sein kann.

Es ist beschrieben, dass bevorzugte Bindemittel Polyacrylsäure oder deren Alkali-, insbesondere Lithium- oder Natrium-Salze, Polyvinylalkohole, Cellulose oder Cellulosederivate, Polyvinylidenfluorid, Polytetrafluorethylen, Polyolefine, Polyimide, insbesondere Polyamidimide, oder thermoplastische Elastomere, insbesondere Ethylen-Propylen-Dien-Terpolymere sind. Besonders bevorzugt sind Polyacrylsäure, Polymethacrylsäure oder Cellulose-Derivate, insbesondere Carboxymethylcellulose. Besonders bevorzugt sind auch die Alkali-, insbesondere Lithium- oder Natrium-Salze, der vorgenannten Bindemittel. Am meisten bevorzugt sind die Alkali-Salze, insbesondere Lithium- oder Natrium-Salze, der Polyacrylsäure oder der Polymethacrylsäure. Es können sämtliche oder vorzugsweise ein Anteil der Säure-Gruppen eines Bindemittels in Form von Salzen vorliegen. Die Bindemittel haben eine Molmasse von vorzugsweise 100.000 bis 1.000.000 g/mol. Es können auch Gemische von zwei oder mehr Bindemitteln eingesetzt werden.

Es ist beschrieben, dass als Graphit allgemein natürlicher oder synthetischer Graphit eingesetzt werden kann. Die Graphitpartikel haben bevorzugt eine volumengewichtete Partikelgrößenverteilung zwischen den Durchmesser-Perzentilen $d_{10}$ > 0,2 $\mu$m und $d_{90}$ < 200 $\mu$m.

Beispiele für Additive sind Porenbildner, Dispergiermittel, Verlaufsmittel oder Dotiermittel, beispielsweise elementares Lithium.

Es ist beschrieben, dass bevorzugte Rezepturen für das Anodenmaterial vorzugsweise 5 bis 95 Gew.-%, insbesondere 60 bis 90 Gew.-% des Silicium enthaltenden Materials, 0 bis 90 Gew.-%, insbesondere 0 bis 40 Gew.-% weitere elektrisch leitende Komponenten, 0 bis 90 Gew.-%, insbesondere 5 bis 40 Gew.-% Graphit, 0 bis 25 Gew.-%, insbesondere 5 bis 20 Gew.-% Bindemittel und 0 bis 80 Gew.-%, insbesondere 0,1 bis 5 Gew.-% Additive enthalten, wobei sich die Angaben in Gew.-% auf das Gesamtgewicht des Anodenmaterials beziehen und sich die Anteile aller Bestandteile des Anodenmaterials auf 100 Gew.-% aufsummieren.

Es ist beschrieben, dass die Verarbeitung der Bestandteile des Anodenmaterials zu einer Anodentinte bzw. -paste bevorzugt in einem Lösungsmittel erfolgt, vorzugsweise ausgewählt aus der Gruppe umfassend Wasser, Hexan, Toluol, Tetrahydrofuran, N-Methylpyrrolidon, N-Ethylpyrrolidon, Aceton, Ethylacetat, Dimethylsulfoxid, Dimethylacetamid und Ethanol sowie Gemischen dieser Lösungsmittel, vorzugsweise unter Verwendung von Rotor-Stator-Maschinen, Hochenergiemühlen, Planetenknetern, Rührwerkskugelmühlen, Rüttelplatten oder Ultraschallgeräten.

Die Anodentinte bzw. -paste weist einen pH-Wert von vorzugsweise 2 bis 7,5 (bestimmt bei 20°C, beispielsweise mit dem pH-Meter von WTW pH 340i mit Sonde SenTix RJD) auf.

Es ist beschrieben, dass die Anodentinte oder -paste beispielsweise auf eine Kupferfolie oder einen anderen Stromsammler aufgerakelt werden kann. Andere Beschichtungsverfahren, wie beispielsweise Rotationsbeschichtung (Spin-Coating), Rollen-, Tauch- oder Schlitzdüsenbeschichtung, Streichen oder Sprühen, können ebenso verwendet werden.

Es ist beschrieben, dass vor dem Beschichten der Kupferfolie mit dem erfindungsgemäßen Anodenmaterial eine Behandlung der Kupferfolie mit einem handelsüblichen Primer kann, beispielsweise auf der Basis von Polymerharzen oder Silanen, erfolgen. Primer können zu einer Verbesserung der Haftung auf dem Kupfer führen, besitzen aber selbst im Allgemeinen praktisch keine elektrochemische Aktivität.

Es ist beschrieben, dass das Anodenmaterial im Allgemeinen bis zur Gewichtskonstanz getrocknet wird. Die Trocknungstemperatur richtet sich nach den eingesetzten Komponenten und dem verwendeten Lösungsmittel. Sie liegt bevorzugt zwischen 20 und 300°C, besonders bevorzugt zwischen 50 und 150°C. Die Schichtdicke, das heißt die Trockenschichtdicke der Anodenbeschichtung ist bevorzugt 2 bis 500 $\mu$m, besonders bevorzugt von 10 bis 300 $\mu$m.

Es ist beschrieben, dass abschließend die Elektrodenbeschichtungen kalandriert werden können, um eine definierte Porosität einzustellen. Die so hergestellten Elektroden weisen bevorzugt Porositäten von 15 bis 85% auf, welche über Quecksilberporosimetrie nach DIN ISO 15901-1 bestimmt werden können. Dabei werden bevorzugt 25 bis 85% des so bestimmbaren Porenvolumens durch Poren bereitgestellt, welche einen Porendurchmesser von 0,01 bis 2 $\mu$m aufweisen.

Ferner ist eine Lithium-Ionen-Batterie umfassend eine Kathode, eine Anode, zwei elektrisch leitende Anschlüsse an den Elektroden, einen Separator und einen Elektrolyten, mit dem der Separator und die beiden Elektroden getränkt sind, sowie ein die genannten Teile aufnehmendes Gehäuse, bei der die Anode nach dem erfindungsgemäßen Verfahren zugängliches Silicium enthaltendes Material enthält, beschrieben.

Der Begriff Lithium-Ionen-Batterie umfasst auch Zellen. Zellen umfassen allgemein eine Kathode, eine Anode, einen Separator und einen Elektrolyten. Lithium-Ionen-Batterien enthalten neben einer oder mehreren Zellen vorzugsweise zusätzlich ein Batteriemanagementsystem. Batteriemanagementsysteme dienen allgemein zur Steuerung von Batterien, beispielsweise mittels elektronischer Schaltungen, insbesondere zur Erkennung des Ladezustands, für den Tiefentladeschutz oder Überladeschutz.

Es ist beschrieben, dass als bevorzugte Kathodenmaterialien Lithiumcobaltoxid, Lithiumnickeloxid, Lithiumnickelcobaltoxid (dotiert oder nicht dotiert), Lithiummanganoxid (Spinell), Lithiumnickelcobaltmanganoxide, Lithiumnickelmanganoxide, Lithiumeisenphosphat, Lithiumcobaltphosphat, Lithiummanganphosphat, Lithiumvanadiumphosphat, oder Lithiumvanadiumoxide erfindungsgemäß eingesetzt werden können.

Es ist beschrieben, dass der Separator im Allgemeinen eine elektrisch isolierende, für Ionen durchlässige Membran, ist, bevorzugt aus Polyolefinen, beispielsweise Polyethylen (PE) oder Polypropylen (PP), oder Polyester bzw. entsprechenden Laminaten. Der Separator kann wie in der Batterieherstellung gebräuchlich alternativ aus Glas- oder Keramikmaterialien bestehen oder damit beschichtet sein. Der Separator trennt bekanntermaßen die erste Elektrode von der zweiten Elektrode und verhindert somit elektronisch leitende Verbindungen zwischen den Elektroden (Kurzschluss).

Es ist beschrieben, dass der Elektrolyt vorzugsweise eine Lösung enthaltend ein oder mehrere Lithiumsalze (= Leitsalz) in einem aprotischen Lösungsmittel ist. Bevorzugt sind Leitsalze ausgewählt aus der Gruppe enthaltend Lithiumhexafluorophosphat, Lithiumhexafluoroarsenat, Lithiumperchlorat, Lithiumtetrafluoroborat, Lithiumimide, Lithiummethide, Lithiumtrifluoromethansulfonat $LiCF_3SO_3$, Lithiumbis(trifluoromethansulfonimid) $LiN(CF_3SO_2)_2$ und Lithiumborate. Die Konzentration des Leitsalzes, bezogen auf das Lösungsmittel, liegt vorzugsweise zwischen 0,5 mol/l und der Löslichkeitsgrenze des entsprechenden Salzes. Besonders bevorzugt beträgt sie 0,8 bis 1,2 mol/l.

Es ist beschrieben, dass als Lösungsmittel bevorzugt cyclische Carbonate, Propylencarbonat, Ethylencarbonat, Fluorethylencarbonat, Dimethylcarbonat, Diethylcarbonat, Ethylmethylcarbonat, Dimethoxyethan, Diethoxyethan, Tetrahydrofuran, 2-Methyltetrahydrofuran, gamma-Butyrolacton, Dioxolan, Acetonitril, organische Kohlensäureester oder Nitrile, einzeln oder als Mischungen daraus, eingesetzt werden.

Es ist beschrieben, dass der Elektrolyt bevorzugt einen Filmbildner, wie beispielsweise Vinylencarbonat oder Fluorethylencarbonat, enthält. Dadurch kann eine signifikante Verbesserung der Zyklenfestigkeit der Anoden enthaltend das nach dem erfindungsgemäßen Verfahren erhaltene Silicium enthaltende Material erreicht werden. Dies wird hauptsächlich der Bildung einer festen Elektrolytzwischenphase auf der Oberfläche von aktiven Partikeln zugeschrieben. Der Anteil des Filmbildners im Elektrolyten beträgt bevorzugt zwischen 0,1 und 20,0 Gew.-%, besonders bevorzugt zwischen 0,2 und 15,0 Gew.-% und am meisten bevorzugt zwischen 0,5 und 10 Gew.-%.

Um die faktischen Kapazitäten der Elektroden einer Lithium-Ionen-Zelle möglichst optimal aufeinander abzustimmen, ist beschrieben, dass es vorteilhaft ist, die Materialien für die positive und negative Elektrode mengenmäßig auszubalancieren. Von besonderer Bedeutung ist in diesem Zusammenhang, dass es beim ersten bzw. initialen Lade-/Entladezyklus von sekundären Lithium-Ionen-Zellen (der sogenannten Formierung) zur Ausbildung einer Deckschicht auf der Oberfläche der elektrochemisch aktiven Materialien in der Anode kommt. Diese Deckschicht wird als "Solid Elektrolyte Interphase" (SEI) bezeichnet und besteht in der Regel vor allem aus Elektrolytzersetzungsprodukten sowie einer gewissen Menge an Lithium, das entsprechend für weitere Lade-/Entladereaktionen nicht mehr zur Verfügung steht. Die Dicke und Zusammensetzung der SEI ist abhängig von der Art und der Qualität des verwendeten Anodenmaterials und der verwendeten Elektrolytlösung.

Es ist beschrieben, dass die SEI im Falle von Graphit besonders dünn ist. Auf Graphit kommt es im ersten Ladeschritt zu einem Verlust von üblicherweise 5 bis 35% des mobilen Lithiums. Dementsprechend sinkt auch die reversible Kapazität der Batterie.

Es ist beschrieben, dass es bei Anoden mit dem nach dem erfindungsgemäßen Verfahren erhaltenen Silicium enthaltenden Aktivmaterial im ersten Ladeschritt zu einem Verlust an mobilem Lithium von vorzugsweise höchstens 30%, besonders bevorzugt höchstens 20% und am meisten bevorzugt höchstens 10% kommt, was deutlich unter den im Stand der Technik, wie beispielsweise in der US 10,147,950 B1, beschriebenen Werten liegt.

Es ist beschrieben, dass eine Lithium-Ionen-Batterie, deren Anode ein nach dem erfindungsgemäßen Verfahren erhältliches Silicium enthaltendes Material enthält, kann in allen üblichen Formen, beispielsweise in gewickelter, gefalteter oder gestapelter Form hergestellt werden.

Alle zur Herstellung solcher Lithium-Ionen-Batterien, wie oben beschrieben, benutzten Stoffe und Materialien sind bekannt. Die Herstellung der Teile derartiger Batterien und ihre Zusammenfügung zu Batterien erfolgt nach den auf dem Gebiet der Batterieherstellung bekannten Verfahren.

Es ist beschrieben, dass sich das nach dem erfindungsgemäßen Verfahren erhaltene Silicium enthaltende Material durch ein deutlich verbessertes elektrochemisches Verhalten auszeichnet und zu Lithium-Ionen-Batterien mit hohen volumetrischen Kapazitäten und hervorragenden Anwendungseigenschaften führt. Das nach dem erfindungsgemäßen Verfahren erhaltene Silicium enthaltende Material ist permeabel für Lithium-Ionen sowie Elektronen und ermöglicht somit den Ladungstransport. Die SEI in Lithium-Ionen-Batterien kann mit dem nach dem erfindungsgemäßen Verfahren erhaltenen Silicium enthaltenden Material in großem Umfang reduziert werden. Zusätzlich löst sich die SEI auf Grund des Designs des nach dem erfindungsgemäßen Verfahren erhaltenen Silicium enthaltenden Materials nicht mehr oder zumindest in weit geringerem Umfang von der Oberfläche des Aktivmaterials ab. All dies führt zu einer hohen Zyklenbeständigkeit entsprechender Lithium-Ionen-Batterien, in deren Anoden das nach dem erfindungsgemäßen Verfahren erhältliche Silicium enthaltende Material enthalten ist.

Die nachfolgenden Beispiele dienen zur weiteren Erläuterung der hier beschriebenen Erfindung.

Folgende analytische Methoden und Geräte wurden zur Charakterisierung eingesetzt:

Anorganische Analytik / Elementaranalyse:

Die in den Beispielen angegebenen C-Gehalte wurden mit einem Leco CS 230 Analysator ermittelt, zur Bestimmung von O- und ggf. N- bzw. H-Gehalten wurde ein Leco TCH-600 Analysator eingesetzt. Die qualitative und quantitative Bestimmung von anderen angegebenen Elementen erfolgte mittels ICP (inductively coupled plasma) Emissionspektrometrie (Optima 7300 DV, Fa. Perkin Elmer). Die Proben wurden dazu in einer Mikrowelle (Microwave 3000, Fa. Anton Paar) sauer aufgeschlossen ($HF/HNO_3$). Die ICP-OES-Bestimmung orientiert sich an der ISO 11885 "Wasserbeschaffenheit - Bestimmung von ausgewählten Elementen durch induktiv gekoppelte Plasma-Atom-Emissionsspektrometrie (ICP-OES) (ISO 11885:2007); Deutsche Fassung EN ISO 11885:2009", die zur Untersuchung saurer, wässriger Lösungen eingesetzt wird (z.B. angesäuerte Trinkwasser-, Abwasser- und andere Wasserproben, Königswasserextrakte von Böden und Sedimenten).

Partikelgrößenbestimmung:

Die Bestimmung der Partikelgrößenverteilung erfolgte im Rahmen dieser Erfindung nach ISO 13320 mittels statischer Laserstreuung mit einem Horiba LA 950. Dabei muss bei der Vorbereitung der Proben besondere Sorgfalt auf die Dispergierung der Partikel in der Messlösung aufgewendet werden, um statt der Größe von Einzelpartikeln nicht die Größe von Agglomeraten zu messen. Die Partikel wurden für die Messung in Ethanol dispergiert. Dazu wurde die Dispersion vor der Messung bei Bedarf 4 min in einem Hielscher Ultraschall-Laborgerät Modell UIS250v mit Sonotrode LS24d5 mit 250 W Ultraschall behandelt.

Oberflächenmessung nach BET:

Die spezifische Oberfläche der Materialien wurde über Gasadsorption mit Stickstoff mit einem Gerät Sorptomatic 199090 (Porotec) oder Gerät SA-9603MP (Horiba) nach der BET-Methode gemessen (Bestimmung nach DIN ISO 9277:2003-05 mit Stickstoff).

Skelettdichte:

Die Skelettdichte, d.h. die Dichte des porösen Festkörpers basierend auf dem Volumen ausschließlich der von außen gaszugänglichen Porenräume, wurde mittels He-Pyknometrie gemäß DIN 66137-2 bestimmt.

Gaszugängliches Porenvolumen:

Das gaszugängliche Porenvolumen nach Gurwitsch wurde durch Gassorptionsmessungen mit Stickstoff gemäß DIN 66134 bestimmt.

Folgende Materialien und Geräte wurden bei der Durchführung experimentellen Beispiele eingesetzt:
Die eingesetzten Reaktoren A, B und C bestanden aus einem zylindrischen Unterteil (Becher) und einem Deckel mit mehreren Anschlüssen (beispielsweise für die Gaszufuhr, Gasabfuhr, Temperatur- und Druckmessung). Das Volumen der drei Reaktoren betrug je 12 Liter. Die Reaktoren wurden elektrisch beheizt. Die Temperaturmessung erfolgte grundsätzlich zwischen der Heizung und dem Reaktor. Die eingesetzten Rührer waren nahezu wandgängige Wendelrührer. Diese hatten eine Höhe, die ca. 50% der lichten Höhe des Reaktorinnenraums entsprach.

Im nicht erfindungsgemäßen Gegenbeispiel 2 wurde ein identischer Reaktor eingesetzt mit der Besonderheit, dass Reaktor A, B und C dasselbe Gefäß war und keine Überführung des Materials zwischen den Schritten stattgefunden hat.

Das eingesetzte $SiH_4$, der Qualität 4.0, wurde bei Linde GmbH erworben.

Die im Beispiel eingesetzten porösen Partikel hatten folgende Eigenschaften:

- Dichte: 2,19 g/cm$^3$ (He-Pyknometrie)
- Oberfläche BET: 2255 m$^2$/g
- Gurvich Volumen: 1,16 cm$^3$/g
- Kohlenstoffgehalt: 93,39 Gew.-% (EA)

- Sauerstoffgehalt: 5,45 Gew.-% (EA)
- Wasserstoffgehalt: 0,70 Gew.-% (EA)
- Mikroporenvolumen: 0,46 cm$^3$/g
- Partikelgrößenverteilung: $d_{50}$ 4,4 $\mu$m

**Beispiel 1**

Herstellung von Silicium enthaltenden Materialien unter Einsatz von Monosilan SiH$_4$ als Silicium-Präkursor im Kaskadenreaktorsystem.

In Phase 1.1 wurde Reaktor A mit 842 g an porösem Material, den porösen Partikeln befüllt und verschlossen. Anschließend wurde Reaktor A in Phase 1.2 auf 350 °C temperiert und für 240 Minuten auf einen Enddruck von 1*10$^{-3}$ bar evakuiert. Das Material wurde dann in Phase 1.3 unter Stickstoffatmospähre in den auf 350 °C geheizten Reaktor B überführt.

In Phase 2.1 wurde das poröse Material in Reaktor B auf 350 °C aufgeheizt. In Phase 2.2 wurde der Reaktor B zunächst auf 1*10$^{-3}$ bar evakuiert. Anschließend wurde in Phase 2.4 eine Menge von 158 g SiH$_4$ mit einem Druck von 15,0 bar beaufschlagt. Reaktor B wurde in Phase 3.1 und 4.1 innerhalb 15 Minuten auf eine Temperatur von 430°C erhitzt, die Temperatur wurde in Phase 4.2 für 70 Minuten gehalten. Der Druck stieg im Verlauf von Phase 4.2 entsprechend Gleichung 2 auf 35,8 bar an. Anschließend wurde der Druck in Reaktor B in Phase 5.1 auf 1,5 bar reduziert und in Phase 5.2 die Temperatur des Reaktors auf 350 °C reduziert. In Folge wurden die Phasen 2.4, 3.1, 4.1, 4.2, 5.1 und 5.2 in der angegebenen Reihenfolgen zehnmal durchlaufen. Hierbei wurden in der angegebenen Reihenfolge in den unterschiedlichen Phasen 2.4 x g SiH$_4$ dosiert (x = 139, 133, 131, 128, 122, 119, 116, 114, 110, 77) dabei stellte sich initial ein Druck von y bar ein (y = 15,0; 15,0; 15,0; 15,0; 15,0; 15,0; 15,0; 15,0; 14,9; 11,0). Reaktor B wurde in allen zehn Fällen in Phase 3.1 und 4.1 innerhalb 15 Minuten auf eine Temperatur von 430°C erhitzt, die Temperatur wurde in den Iterationen der Phase 4.2 für 60 Minuten gehalten. Der Druck stieg im Verlauf von Phase 4.2 entsprechend Gleichung 2 auf z bar an(z = 35,6; 35,0; 34,2; 33,4; 33,1; 32,6; 32,0; 31,5; 31,8; 23,4). Im Anschluss an Phase 4.2 der ersten neun Wiederholungen wurde in Phase 5.1 der Druck auf 1,5 bar reduziert und Reaktor B kühlte innerhalb von 30 Minuten in Phase 5.2 auf eine Temperatur von 350 °C ab. Nach der zehnten und letzten Wiederholung von Phase 4.2 wurde unter Auslassung von Phase 5 in Phase 6.1 der Druck in Reaktor B auf auf 1,0 bar reduziert. Anschließend wurde das heiße Material in Phase 6.2 durch eine Rohrverbindung in Reaktor C überführt. In Phase 6.3 wurde ein Druck von 4,5 bar mit Stickstoff in Reaktor C erzeugt und das Silicium enthaltende Material kühlte in Reaktor C innerhalb von 90 Minuten auf eine Temperatur von 70 °C ab. Anschließend wurde in Phase 7.1 Reaktor C fünfmal mit Stickstoff, zehnmal mit Magerluft mit einem Sauerstoffanteil von 5%, zehnmal mit Magerluft mit einem Sauerstoffanteil von 10%, zehnmal mit Magerluft mit einem Sauerstoffanteil von 15% und anschließend zehnmal mit Luft gespült. Es wurden in Phase 7.2 eine Menge von 1992 g eines Silicium enthaltenden Materials in Form eines schwarzen, feinen Feststoffs isoliert. Das Silicium enthaltende Material hatte folgende Eigenschaften

- Oberfläche BET: 43 m$^2$/g
- Kohlenstoffgehalt: 40,2 Gew.-% (EA)
- Sauerstoffgehalt: 2,77 Gew.-% (EA)
- Siliciumgehalt: 57,0 Gew.-% (EA)

Insgesamt dauerte der Prozess 36 Stunden. Die drei Reaktoren waren alle drei gleichzeitig im Betrieb, der zeitbestimmende Schritt für den Kaskadenreaktor ist der Prozess in Reaktor B, dieser betrug in diesem Fall 18 h.

**Gegenbeispiel 2 (nicht erfindungsgemäß)**

Herstellung von Silicium enthaltenden Materialien unter Einsatz von Monosilan SiH$_4$ als Silicium-Präkursor im Reaktor (Reaktor A, B und C aus Beispiel 1 sind für das Gegenbeispiel das gleiche Druckgefäß).

In Phase 1.1 wurde der Reaktor mit 842 g an porösem Material befüllt und verschlossen. Anschließend wurde der Reaktor in Phase 1.2 auf 350 °C temperiert und für 240 Minuten auf einen Enddruck von 1*10$^{-3}$ bar evakuiert. Anschließend wurde in Phase 2.4 eine Menge 318 g SiH$_4$ mit einem Druck von 15,0 bar beaufschlagt. Der Reaktor wurde in Phase 3.1 und 4.1 innerhalb 15 Minuten auf eine Temperatur von 430°C erhitzt, die Temperatur wurde in Phase 4.2 für 70 Minuten gehalten. Der Druck stieg im Verlauf von Phase 4.2 entsprechend Gleichung 2 auf 35,8 bar an. Anschließend wurde der Druck im Reaktor in Phase 5.1 auf 1,5 bar reduziert und in Phase 5.2 die Temperatur des Reaktors auf 350 °C reduziert. In Folge wurden die Phasen 2.4, 3.1, 4.1, 4.2, 5.1 und 5.2 in der angegebenen Reihenfolgen zehnmal durchlaufen. Hierbei wurden in der angegebenen Reihenfolge in den unterschiedlichen Phasen 2.4 x g SiH$_4$ dosiert (x = 137, 130, 131, 130, 123, 120, 118, 116, 111, 75) dabei stellte sich initial ein Druck von y bar ein (y = 15,0; 15,0; 15,0; 15,0; 15,0; 15,0; 14,9; 15,0; 15,0; 11,0). Der Reaktor wurde in allen zehn Fällen in Phase 3.1 und 4.1 innerhalb 15 Minuten auf eine Temperatur von 430°C erhitzt, die Temperatur wurde in Phase 4.2 für 60 Minuten gehalten. Der Druck stieg im Verlauf von Phase 4.2 entsprechend Gleichung 2 auf z bar an (z = 35,7; 35,2; 34,0; 33,3; 33,1; 32,8; 32,0; 31,3; 31,5; 23,74). Im Anschluss an Phase 4.2 der ersten neun Wiederholungen wurde in Phase 5.1 der Druck auf 1,5 bar reduziert und der Reaktor kühlte innerhalb von 30 Minuten in Phase 5.2 auf eine Temperatur von 350 °C ab. Nach der zehnten und letzten Wiederholung von Phase 4.2 wurde unter Auslassung von Phase 5 in Phase 6.1 der Druck im Reaktor auf 1,0 bar reduziert. In Phase 6.3 wurde ein Druck von 4,5 bar mit Stickstoff im Reaktor erzeugt und das Silicium enthaltende Material kühlte innerhalb von 14 Stunden auf eine Temperatur von 70 °C ab. Anschließend wurde in Phase 7.1 der Reaktor fünfmal mit Stickstoff, zehnmal mit Magerluft mit einem Sauerstoffanteil von 5%, zehnmal mit Magerluft mit einem Sauerstoffanteil von 10%, zehnmal mit Magerluft mit einem Sauerstoffanteil von 15% und anschließend zehnmal mit Luft gespült. Es wurden in Phase 7.2 eine Menge von 1986 g eines Silicium enthaltenden Materials in Form eines schwarzen, feinen Feststoffs isoliert. Das Silicium enthaltende Material hatte folgende Eigenschaften

- Oberfläche BET: 39 m$^2$/g
- Kohlenstoffgehalt: 39,6 Gew.-% (EA)
- Sauerstoffgehalt: 2,87 Gew.-% (EA)
- Siliciumgehalt: 57,0 Gew.-% (EA)

Insgesamt dauerte der Prozess 47 Stunden.

**Beispiel 3:**

Elektrochemische Charakterisierung der Silicium enthaltenden Materialien in Verwendung als Aktivmaterialien in Anoden von Lithium-Ionen-Batterien:

29,71 g Polyacrylsäure (bei 85°C bis zur Gewichtskonstanz getrocknet; Sigma-Aldrich, Mw ~450.000 g/mol) und 756,6 g deionisiertes Wasser wurden mittels Schüttler (290 1/min) für 2,5 h bis zur vollständigen Lösung der Polyacrylsäure bewegt. Zu der Lösung wurde Lithiumhydroxid Monohydrat (Sigma-Aldrich) portionsweise hinzugegeben, bis der pH-Wert bei 7,0 lag (gemessen mit pH-Meter WTW pH 340i und Sonde SenTix RJD). Die Lösung wurde anschließend mittels Schüttler weitere 4 h durchmischt. 3,87 g der neutralisierten Polyacrylsäure-Lösung und 0,96 g Graphit (Imerys, KS6L C) wurden in einem 50 ml Gefäß vorgelegt und in einem Planetenmischer (SpeedMixer, DAC 150 SP) bei 2000 rpm vermengt. Anschließend wurden jeweils 3,40 g der Silicium enthaltenden Materialien aus den Beispielen 1 und 2 bei 2000 rpm für 1 min untergerührt. Anschließend wurden 1,21 g einer 8 prozentigen Leitrußdispersion und 0,8 g deionisiertes Wasser zugegeben und bei 2000 rpm am Planetenmischer eingearbeitet. Anschließend erfolgte die Dispergierung am Dissolver für 30 min bei 3000 rpm unter konstanten 20°C. Die Entgasung der Tinte erfolgte wieder im Planetenmischer bei 2500 rpm für 5 min unter Vakuum. Die fertige Dispersion wurde nun mittels eines Filmziehrahmens mit 0,1 mm Spalthöhe (Erichsen, Modell 360) auf eine Kupferfolie mit einer Dicke von 0,03 mm (Schlenk Metallfolien, SE-Cu58) aufgebracht. Die so hergestellte Anodenbeschichtung wurde anschließend 60 min bei 50°C und 1 bar Luftdruck getrocknet. Das mittlere Flächengewicht der trockenen Anodenbeschichtung betrug 2,1 mg/cm$^2$ und die Beschichtungsdichte 0,9 g/cm$^3$.

Die elektrochemischen Untersuchungen wurden an einer Knopfzelle (Typ CR2032, Hohsen Corp.) in 2-Elektroden-Anordnung durchgeführt. Die Elektrodenbeschichtung wurde als Gegenelektrode bzw. negative Elektrode (Dm = 15 mm) eingesetzt, eine Beschichtung auf Basis von Lithium-Nickel-Mangan-Kobaltoxid 6:2:2 mit Gehalt von 94,0% und mittlerem Flächengewicht von 15,9 mg/cm$^2$ (bezogen von der Firma SEI) als Arbeitselektrode bzw. positive Elektrode (Dm = 15 mm) verwendet. Ein mit 60 μl Elektrolyt getränktes, Glasfaser-Filterpapier (Whatman, GD Type D) diente als Separator (Dm = 16 mm). Der verwendete Elektrolyt bestand aus einer 1,0 molaren Lösung von Lithiumhexafluorophosphat in einem 1:4 (v/v) Gemisch von Fluorethylencarbonat und Diethylcarbonat. Der Bau der Zelle erfolgte in einer Glovebox (< 1 ppm H$_2$O, O$_2$), der Wassergehalt in der Trockenmasse aller verwendeten Komponenten lag unterhalb von 20 ppm.

Die elektrochemische Testung wurde bei 20°C durchgeführt. Das Laden der Zelle erfolgte im cc/cv-Verfahren (constant current / constant voltage) mit konstantem Strom von 5 mA/g (entsprechend C/25) im ersten Zyklus und von 60 mA/g (entsprechend C/2) in den darauffolgenden Zyklen und nach Erreichen der Spannungsgrenze von 4,2 V mit konstanter Spannung bis Unterschreiten eines Stroms von 1,2 mA/g (entsprechend C/100) bzw. 15 mA/g (entsprechend C/8). Das Entladen der Zelle erfolgte im cc-Verfahren (constant current) mit konstantem Strom von 5 mA/g (entsprechend C/25) im ersten Zyklus und von 60 mA/g (entsprechend C/2) in den darauffolgenden Zyklen bis Erreichen der Spannungsgrenze von 2,5 V. Der gewählte spezifische Strom bezog sich auf das Gewicht der Beschichtung der positiven Elektrode. Das Verhältnis von Lade- zu Entladekapazität der Zelle wird als Coulomb-Effizienz bezeichnet. Die Elektroden wurden so gewählt, dass ein Kapazitätsverhältnis von Kathode zu Anode von 1:1,2 eingestellt wurde.

Die Ergebnisse der elektrochemischen Testung der Vollzelle von Lithium-Ionen-Batterien enthaltend die Aktivmaterialien aus den Beispielen 1 und 2 sind in Tabelle 1 aufgeführt.

**Tabelle 1:** Analytische Daten der Silicium enthaltenden Materialien:

| Beispielnr. | Silicium-gehalt [Gew.-%] (ICP) | Oberfläche BET [m²/g] | Sauerstoff-gehalt [Gew.-%] (EA) | Rev. spez. Anodenkapa-zität im 2. Zyklus [mAh/g] | Zyklenzahl mit ≥ 80% Kapazitäts-erhalt | Coulomb-effizienz Formierung [%] |
|---|---|---|---|---|---|---|
| 1 | 57 | 43 | 2,77 | 1120 | 430 | 84 |
| 2* | 57 | 39 | 2,87 | 1080 | 398 | 83 |

*nicht erfindungsgemäß

In Vergleichsbeispiel 2 wurden in einem Reaktor mit einem Volumen von 12 l nach einem nicht erfindungsgemäßen Verfahren innerhalb von 48 h 1986 g Material hergestellt, in Beispiel 1 wurden nach dem erfindungsgemäßen Verfahren in drei Reaktoren mit einem Volumen von 12 l innerhalb von 18 Stunden 1992 g Material hergestellt. Damit wurden in Beispiel 1 eine um den Faktor 2,5 höhere Materialausbeute in Bezug auf die Zeit erzielt als im Fall von Beispiel 2.

**Patentansprüche**

1.   Verfahren zur Herstellung von Silicium enthaltenden Materialien durch thermische Zersetzung von einem oder mehreren Silicium-Präkursoren in Anwesenheit von einem oder mehreren porösen Partikeln, wobei Silicium in Poren und auf der Oberfläche der porösen Partikel abgeschieden wird, in einem Kaskadenreaktorsystem umfassend mehrere Reaktoren.

2.   Verfahren nach Anspruch 1, welches zumindest die Phasen 1 bis 7 umfasst:

Phase 1:   Befüllen eines Reaktors A mit porösen Partikeln und Vorbehandlung der Partikel,
Phase 2:   Transfer der vorbehandelten Partikel in einen Reaktor B und Beaufschlagen des Reaktors mit einer Reaktivkomponente enthaltend zumindest einen Silicium-Präkursor,
Phase 3:   Aufheizen des Reaktors B auf eine Zieltemperatur, bei der die Zersetzung des Silicium-Präkursors im Reaktor beginnt,
Phase 4:   Zersetzung des Silicium-Präkursors unter Abscheidung von Silicium in Poren und auf der Oberfläche der porösen Partikel wobei die Silicium enthaltenden Materialien entstehen und wobei der Druck auf mindestens 7 bar ansteigt,
Phase 5:   Abkühlen des Reaktors B,
Phase 6:   Entfernen von im Zuge der Abscheidung gebildeten gasförmigen Reaktionsprodukten aus dem Reaktor B und Transfer der Silicium enthaltenden Materialien in einen Reaktor C,
Phase 7:   Entnahme der Silicium enthaltenden Materialien aus dem Reaktor C.

3.   Verfahren nach Anspruch 2, bei dem die Phase 1 wie folgt ausgestaltet ist:
Phase 1

Phase 1.1:   Befüllen des Reaktors A mit den porösen Partikeln,
Phase 1.2:   Vorbehandlung der Partikel in Reaktor A,
Phase 1.3:   Transfer der vorbehandelten Partikel in den Reaktor B oder Zwischenlagerung in einen Vorratsbehälter D und anschließender Transfer in den Reaktor B, oder das Material verbleibt in Reaktor A.

**4.** Verfahren nach Anspruch 2 oder 3, bei dem die Phase 2 wie folgt ausgestaltet ist:
Phase 2

Phase 2.1:  Aufheizen oder Abkühlen der Partikel in Reaktor B,

Phase 2.4:  Beaufschlagen des Reaktors B mit mindestens einer Reaktivkomponente enthaltend zumindest einen Silicium-Präkursor.

**5.** Verfahren nach Anspruch 2 bis 4, bei dem die Phase 3 wie folgt ausgestaltet ist:
Phase 3

Phase 3.1:  Aufheizen des Reaktors B auf eine Zieltemperatur, bei der die Zersetzung der Reaktivkomponente in Reaktor B beginnt.

**6.** Verfahren nach Anspruch 2 bis 5, bei dem die Phase 4 wie folgt ausgestaltet ist:

Phase 4.1:  Zersetzung des Silicium-Präkursors unter Abscheidung von Silicium in Poren und auf der Oberfläche der porösen Partikel, wobei der Druck auf mindestens 7 bar ansteigt

Phase 4.2:  Einstellen einer Mindesttemperatur oder eines Temperaturprofils für einen definierten Zeitraum in dem ein Druck von mindestens 7 bar entsteht.

**7.** Verfahren nach Anspruch 2 bis 6, bei dem die Phase 5 wie folgt ausgestaltet ist:
Phase 5

Phase 5.1:  Einstellung des Drucks in Reaktor B auf einen definierten Druck.

Phase 5.2:  Abkühlen des Reaktors B auf eine definierte Temperatur oder ein definiertes Temperaturprofil.

**8.** Verfahren nach Anspruch 2 bis 7, bei dem die Phase 6 wie folgt ausgestaltet ist:
Phase 6

Phase 6.1:  Entfernen von im Zuge der Abscheidung gebildeten gasförmigen Reaktionsprodukten aus dem Reaktor B,

Phase 6.2:  Transfer der Partikel in Reaktor C oder Zwischenlagerung in einen Vorratsbehälter E und anschließender Transfer in Reaktor C, oder das Material verbleibt in Reaktor B.

Phase 6.3:  Einstellung von Reaktor C auf eine definierte Temperatur oder ein definiertes Temperaturprofil und einem definierten Druck.

**9.** Verfahren nach Anspruch 2 bis 8, bei dem die Phase 7 wie folgt ausgestaltet ist:
Phase 7

Phase 7.1:  Nachbehandlung der Partikel in Reaktor C zur Deaktivierung der Partikeloberflächen

Phase 7.2:  Abkühlen der Partikel auf eine definierte Temperatur und Entnahme von Silicium enthaltenden Materialien aus Reaktor C, und vorzugsweise direkte Überführung in einen Vorratsbehälter E oder direkte Abfüllung in ein geeignetes Gebinde.

**10.** Verfahren nach Anspruch 2 bis 9, bei dem der Kaskadenreaktor aus nur zwei voneinander abhängigen Reaktoren besteht, wobei die Phasen 1 bis 6.1 im gleichen Reaktor durchgeführt werden und Phase 1.3 entfällt oder die Phasen 2 bis 7 in einem Reaktor durchgeführt werden und die Phase 6.2 entfällt.

**11.** Verfahren nach Anspruch 2 oder 6 bis 10, bei dem der Druck in Reaktor B in Phase 4.1 und 4.2 zumindest 10 bar erreicht.

**12.** Verfahren nach Anspruch 2 oder, 6 bis 11, bei dem die Temperatur in Reaktor B in Phase 4.1 und 4.2 im Bereich von 100 bis 1000°C liegt.

13. Verfahren nach einem der vorangehenden Ansprüche, bei dem der Silicium-Präkursor mindestens eine Reaktivkomponente enthält, die ausgewählt wird aus Silicium-Wasserstoff-Verbindungen, Chlor-haltigen Silanen, sowie höheren linearen, verzweigten oder cyclischen Homologen von Chlor-haltigen Silanen, chlorierten und teilchlorierten Oligo- und Polysilanen, Methylchlorsilanen, oder Mischungen davon.

14. Verfahren nach einem der vorangehenden Ansprüche, bei dem die porösen Partikel ausgewählt werden aus amorphen Kohlenstoffen, Siliciumdioxid, Bornitrid, Siliciumcarbid sowie Siliciumnitrid oder auch Mischwerkstoffe auf Basis dieser Materialien.

**Claims**

1. Process for producing silicon-containing materials by thermal decomposition of one or more silicon precursors in the presence of one or more porous particles, where silicon is deposited in pores and on the surface of the porous particles, in a cascade reactor system comprising a plurality of reactors.

2. Process according to Claim 1, which comprises at least the Phases 1 to 7:

   Phase 1: filling a reactor A with porous particles and pretreating the particles,
   Phase 2: transferring the pretreated particles into a reactor B and charging the reactor with a reactive component comprising at least one silicon precursor,
   Phase 3: heating the reactor B to a target temperature, at which the silicon precursor begins to decompose in the reactor,
   Phase 4: decomposing the silicon precursor, with deposition of silicon in pores and on the surface of the porous particles, with formation of the silicon-containing materials and with the pressure increasing to at least 7 bar,
   Phase 5: cooling the reactor B,
   Phase 6: removing gaseous reaction products, formed in the course of the deposition, from the reactor B and transferring the silicon-containing materials into a reactor C,
   Phase 7: withdrawing the silicon-containing materials from the reactor C.

3. Process according to Claim 2, wherein Phase 1 is configured as follows:
   Phase 1

   Phase 1.1 : filling the reactor A with the porous particles,
   Phase 1.2 : pretreating the particles in reactor A,
   Phase 1.3 : transferring the pretreated particles into the reactor B, or interim storage into a reservoir vessel D and subsequent transfer into the reactor B, or the material remains in reactor A.

4. Process according to Claim 2 or 3, wherein Phase 2 is configured as follows:
   Phase 2

   Phase 2.1: heating or cooling of the particles in reactor B,
   Phase 2.4: charging the reactor B with at least one reactive component comprising at least one silicon precursor.

5. Process according to Claim 2 to 4, wherein Phase 3 is configured as follows:
   Phase 3

   Phase 3.1: heating the reactor B to a target temperature, at which the reactive component begins to decompose in reactor B.

**6.** Process according to Claim 2 to 5, wherein Phase 4 is configured as follows:

Phase 4.1: decomposing the silicon precursor, with deposition of silicon in pores and on the surface of the porous particles, with the pressure increasing to at least 7 bar

Phase 4.2: establishing a minimum temperature or a temperature profile for a defined period in which a pressure of at least 7 bar comes about.

**7.** Process according to Claim 2 to 6, wherein Phase 5 is configured as follows:
Phase 5

Phase 5.1: adjusting the pressure in reactor B to a defined pressure.

Phase 5.2: cooling the reactor B to a defined temperature or a defined temperature profile.

**8.** Process according to Claim 2 to 7, wherein Phase 6 is configured as follows:
Phase 6

Phase 6.1 : removing gaseous reaction products, formed in the course of the deposition, from the reactor B,

Phase 6.2 : transferring the particles into reactor C, or interim storage into a reservoir vessel E and subsequent transfer into reactor C, or the material remains in reactor B,

Phase 6.3 : adjusting reactor C to a defined temperature or a defined temperature profile and a defined pressure.

**9.** Process according to Claim 2 to 8, wherein Phase 7 is configured as follows:
Phase 7

Phase 7.1: aftertreating the particles in reactor C to deactivate the particle surfaces,

Phase 7.2: cooling the particles to a defined temperature and withdrawing silicon-containing materials from reactor C, and preferably direct transfer into a reservoir vessel E or direct filling into a suitable container.

**10.** Process according to Claim 2 to 9, wherein the cascade reactor consists of only two mutually dependent reactors, where Phases 1 to 6.1 are carried out in the same reactor and Phase 1.3 is omitted, or Phases 2 to 7 are carried out in a reactor and Phase 6.2 is omitted.

**11.** Process according to Claim 2 or 6 to 10, wherein the pressure in reactor B in Phase 4.1 and 4.2 reaches at least 10 bar.

**12.** Process according to Claim 2 or 6 to 11, wherein the temperature in reactor B in Phase 4.1 and 4.2 is in the range from 100 to 1000°C.

**13.** Process according to any of the preceding claims, wherein the silicon precursor comprises at least one reactive component which is selected from silicon-hydrogen compounds, chlorine-containing silanes, and also higher linear, branched or cyclic homologs of chlorine-containing silanes, chlorinated and part-chlorinated oligo- and polysilanes, methylchlorosilanes or mixtures thereof.

**14.** Process according to any of the preceding claims, wherein the porous particles are selected from amorphous carbons, silicon dioxide, boron nitride, silicon carbide and silicon nitride or else hybrid materials based on these materials.


**Revendications**

**1.** Procédé de préparation de matériaux contenant du silicium par décomposition thermique d'un ou de plusieurs précurseurs de silicium en présence d'une ou de plusieurs particules poreuses, du silicium étant déposé dans des pores et sur la surface des particules poreuses, dans un système de réacteur en cascade comprenant plusieurs réacteurs.

**2.** Procédé selon la revendication 1, qui comprend au moins les phases 1 à 7 :

phase 1 : remplissage d'un réacteur A par des particules poreuses et prétraitement des particules,
phase 2 : transfert des particules prétraitées dans un réacteur B et chargement dans le réacteur d'un composant réactif contenant au moins un précurseur de silicium,
phase 3 : chauffage du réacteur B à une température cible à laquelle démarre la décomposition du précurseur de silicium dans le réacteur,
phase 4 : décomposition du précurseur de silicium avec dépôt de silicium dans des pores et sur la surface des particules poreuses, les matériaux contenant du silicium étant formés et la pression s'élevant à au moins 7 bars,
phase 5 : refroidissement du réacteur B,
phase 6 : élimination du réacteur B des produits gazeux de réaction formés au cours du dépôt et transfert des matériaux contenant du silicium dans un réacteur C,
phase 7 : prélèvement des matériaux contenant du silicium du réacteur C.

**3.** Procédé selon la revendication 2, dans lequel la phase 1 est conçue comme suit :
phase 1 :

phase 1.1 : remplissage du réacteur A par les particules poreuses,
phase 1.2 : prétraitement des particules dans le réacteur A,
phase 1.3 : transfert des particules prétraitées dans le réacteur B ou stockage intermédiaire dans un récipient de stockage D et transfert consécutif dans le réacteur B, ou le matériau reste dans le réacteur A.

**4.** Procédé selon la revendication 2 ou 3, dans lequel la phase 2 est conçue comme suit :
phase 2 :

phase 2.1 : chauffage ou refroidissement des particules dans le réacteur B,
phase 2.4 : chargement dans le réacteur B d'au moins un composant réactif contenant au moins un précurseur de silicium.

**5.** Procédé selon la revendication 2 à 4, dans lequel la phase 3 est conçue comme suit :
phase 3 :
phase 3.1 : chauffage du réacteur B à une température cible à laquelle démarre la décomposition du composant réactif dans le réacteur B.

**6.** Procédé selon la revendication 2 à 5, dans lequel la phase 4 est conçue comme suit :

phase 4.1 : décomposition du précurseur de silicium avec dépôt de silicium dans des pores et sur la surface des particules poreuses, la pression s'élevant à au moins 7 bars,
phase 4.2 : réglage d'une température minimale ou d'un profil de température pour une période de temps définie pendant laquelle une pression d'au moins 7 bars s'établit.

**7.** Procédé selon la revendication 2 à 6, dans lequel la phase 5 est conçue comme suit :
phase 5 :

phase 5.1 : réglage de la pression dans le réacteur B à une pression définie,
phase 5.2 : refroidissement du réacteur B à une température définie ou à un profil de température défini.

**8.** Procédé selon la revendication 2 à 7, dans lequel la phase 6 est conçue comme suit :
phase 6 :

phase 6.1 : élimination du réacteur B des produits gazeux de réaction formés au cours du dépôt,
phase 6.2 : transfert des particules dans le réacteur C ou stockage intermédiaire dans un récipient de stockage E et transfert consécutif dans le réacteur C, ou le matériau reste dans le réacteur B,
phase 6.3 : réglage du réacteur C à une température définie ou à un profil de température défini et à une pression définie.

**9.** Procédé selon la revendication 2 à 8, dans lequel la phase 7 est conçue comme suit :
phase 7 :

phase 7.1 : post-traitement des particules dans le réacteur C afin de désactiver la surface des particules,
phase 7.2 : refroidissement des particules à une température définie et prélèvement des matériaux contenant du silicium du réacteur C et, de préférence, transfert direct dans un récipient de stockage E ou conditionnement direct dans un emballage approprié.

10. Procédé selon la revendication 2 à 9, dans lequel le réacteur en cascade est constitué de seulement deux réacteurs dépendant l'un de l'autre, les phases 1 à 6.1 étant réalisées dans le même réacteur et la phase 1.3 étant omise ou les phases 2 à 7 étant réalisées dans un réacteur et la phase 6.2 étant omise.

11. Procédé selon la revendication 2 ou 6 à 10, dans lequel la pression dans le réacteur B dans les phases 4.1 et 4.2 atteint au moins 10 bars.

12. Procédé selon la revendication 2 ou 6 à 11, dans lequel la température dans le réacteur B dans les phases 4.1 et 4.2 se situe dans la plage de 100 à 1000°C.

13. Procédé selon l'une des revendications précédentes, dans lequel le précurseur de silicium contient au moins un composant réactif choisi parmi les composés de silicium-hydrogène, les silanes contenant du ainsi que les homologues supérieurs linéaires, ramifiés ou cycliques de silanes contenant du chlore, les oligosilanes et les polysilanes chlorés et partiellement chlorés, les méthylchlorosilanes ou leurs mélanges.

14. Procédé selon l'une des revendications précédentes, dans lequel les particules poreuses sont choisies parmi les carbones amorphes, le dioxyde de silicium, le nitrure de bore, le carbure de silicium et le nitrure de silicium ou encore les matériaux mixtes à base de ces matériaux.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1730800 B1
- US 10559812 B2
- US 10819400 B2
- EP 3335262 B1
- US 10147950 B2
- US 10424786 B1
- WO 2012097969 A1
- US 10508335 B1
- GB 2587326 A
- GB 2584615 A
- US 10147950 B1

**In der Beschreibung aufgeführte Nicht-Patentliteratur**

- **M. OBROVAC** ; **V.L. CHEVRIER**. *Chem. Rev.*, 2014, vol. 114, 11444
- **MOTEVALIAN et al.** *Ind. Eng. Chem. Res.*, 2017, vol. 56, 14995
- **J.O. ODDEN et al.** *Solar Energy Mat. & Solar Cells*, 2005, vol. 86, 165